# EUROPEAN PATENT APPLICATION

(11) **EP 4 761 535 A1**
(43) Date of publication of application: **17.06.2026**
(21) Application number: 25211119.0
(22) Date of filing: 24.10.2025
(51) Int. Cl.: H10K 50/11, H10K 59/131, H10K 59/38, H10K 59/80

(54) **DISPLAY APPARATUS**

(30) Priority: 12.12.2024 KR 20240185169
(71) Applicant: LG Display Co., Ltd., Seoul, 07336 (KR)
(72) Inventor: Kang, KyungYun, 10845 Paju-si (KR); Ahn, JiYoung, 10845 Paju-si (KR); Kim, AhnKi, 10845 Paju-si (KR); Shin, Hyeonjeong, 10845 Paju-si (KR)
(74) Representative: Mellor, Rupert James Edward

(57) **Abstract**

A display apparatus comprising: a substrate including a display area in which a plurality of pixels are arranged and a non-display area around the display area, each of the plurality of pixels having a plurality of subpixels; a cathode electrode on the substrate, the cathode electrode disposed in the display area and in a part of the non-display area; an organic layer under the cathode electrode in the display area and in a portion of the non-display area; an organic layer shielding portion in the non-display area, wherein the organic layer is disposed in the portion of the non-display area without being disposed in the organic layer shielding portion; and a low-reflection structure overlapping at least a part of the organic layer shielding portion, the low-reflection structure between the cathode electrode and the substrate in the non-display area.

## Description

### CROSS-REFERENCE TO RELATED APPLICATION

This application claims the benefit of Republic of the Korea Patent Application No. 10-2024-0185169 filed on December 12, 2024, which is hereby incorporated by reference in its entirety.

### BACKGROUND

### Field of Technology

The present disclosure relates to a display apparatus.

### Discussion of the Related Art

Since an organic light emitting display apparatus has a high response speed and low power consumption and self-emits light without requiring a separate light source unlike a liquid crystal display apparatus, there is no problem in a viewing angle and thus the organic light emitting display apparatus has received attention as a next-generation flat panel display apparatus.

Such a display apparatus includes a display panel (or a substrate), and the display panel displays an image through light emission from a light-emitting element layer including an organic light-emitting layer interposed between a pixel electrode and an opposing electrode.

Meanwhile, the display apparatus (or display panel) may include a display area provided with the light-emitting element layer and a non-display area including a bezel area. To simplify the process, the organic light-emitting layer and the opposing electrode are arranged to extend from the display area to the non-display area. However, if the organic light-emitting layer extends to the non-display area, there is a problem in that moisture and oxygen penetrate into the display apparatus (or display panel) through the organic light-emitting layer, thereby reducing a lifespan of the light-emitting element layer.

### SUMMARY

An embodiment of the present disclosure is to provide a display apparatus in which moisture penetration can be reduced or prevented.

Further, an embodiment of the present disclosure is to provide a display apparatus in which external light reflection can be reduced or prevented.

Further, an embodiment of the present disclosure is to provide a display apparatus capable of improving a visibility of an image.

Further, an embodiment of the present disclosure is to provide a display apparatus in which hydrogen penetration can be reduced or prevented.

Further, an embodiment of the present disclosure is to provide a display apparatus in which a size of a non-display area (or a bezel) can be reduced.

Further, an embodiment of the present disclosure is to provide a display apparatus in which production energy can be reduced through process optimization.

The problems to be solved by the examples of the present disclosure are not limited to those mentioned above, and other problems not mentioned will be apparent to one of ordinary skill in the art to which the technical spirits of the present disclosure belong from the following description.

In one embodiment, a display apparatus comprises: a substrate including a display area in which a plurality of pixels are arranged and a non-display area around the display area, each of the plurality of pixels having a plurality of subpixels; a cathode electrode on the substrate, the cathode electrode disposed in the display area and in a part of the non-display area; an organic layer under the cathode electrode in the display area and in a portion of the non-display area; an organic layer shielding portion in the non-display area, wherein the organic layer is disposed in the portion of the non-display area without being disposed in the organic layer shielding portion; and a low-reflection structure overlapping at least a part of the organic layer shielding portion, wherein the low-reflection structure is disposed between the cathode electrode and the substrate in the non-display area.

In one embodiment, a display apparatus comprises: a substrate including a display area and a non-display area around the display area; a gate driver circuit in a first portion of the non-display area; a signal line in a second portion of the non-display area that is spaced apart from the first portion of the non-display area; an organic light emitting layer in the display area and the non-display area; and a cathode electrode on the organic light emitting layer in the display area and a part of the non-display area, wherein the organic light emitting layer is disposed over the gate driver circuit in the first portion of the non-display area and is disposed over the signal line in a second portion of the non-display area without being disposed over a third portion of the non-display area that is between the first portion and the second portion of the non-display area.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a schematic plan view of a display apparatus according to one embodiment of the present disclosure.
FIG. 2 is schematic enlarged view of part A of FIG. 1 according to one embodiment of the present disclosure.
FIG. 3 is a schematic cross-sectional view of the line I-I' shown in FIG. 1 according to one embodiment of the present disclosure.
FIG. 4 is a schematic cross-sectional view of the line II-II' shown in FIG. 2 according to one embodiment of the present disclosure.
FIG. 5 is a drawing showing another example of FIG. 4 according to one embodiment of the present disclosure.
FIG. 6 is a plan view showing a display apparatus according to the second embodiment of the present disclosure.
FIG. 7 is a schematic cross-sectional view of the line III-III' shown in FIG. 6 according to one embodiment of the present disclosure.
FIG. 8 is a drawing showing a display apparatus according to the third embodiment of the present disclosure, and is a modified example of FIG. 4.
FIG. 9 is a drawing showing another example of FIG. 8, which is a modified example of FIG. 7 according to one embodiment of the present disclosure.
FIG. 10 is a plan view showing a display apparatus according to the fourth embodiment of the present disclosure.
FIG. 11 is a schematic cross-sectional view of line IV-IV' shown in FIG. 10 according to one embodiment of the present disclosure.
FIGS. 12A to 12E are schematic plan views showing various examples of the low-reflection structure of a display apparatus according to the fourth embodiment of the present disclosure.
FIG. 13 is a drawing showing a display apparatus according to the fifth embodiment of the present disclosure, which is another modified example of FIG. 4.
FIG. 14 is a schematic enlarged view of part B of FIG. 1 according to one embodiment of the present disclosure.
FIG. 15 is a schematic cross-sectional view of line V-V' shown in FIG. 14 according to one embodiment of the present disclosure.

### DETAILED DESCRIPTION

Reference will now be made in detail to the embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings.

The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely one example, and thus, the present disclosure is not limited to the illustrated details.

Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present disclosure are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms.

These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in co-dependent relationship.

Hereinafter, the preferred embodiments of the present disclosure will be described in detail with reference to the accompanying drawings.

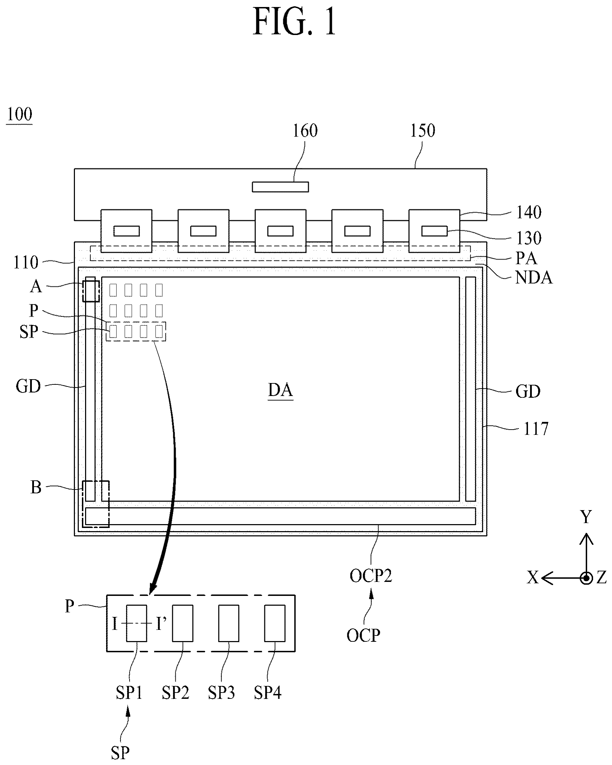

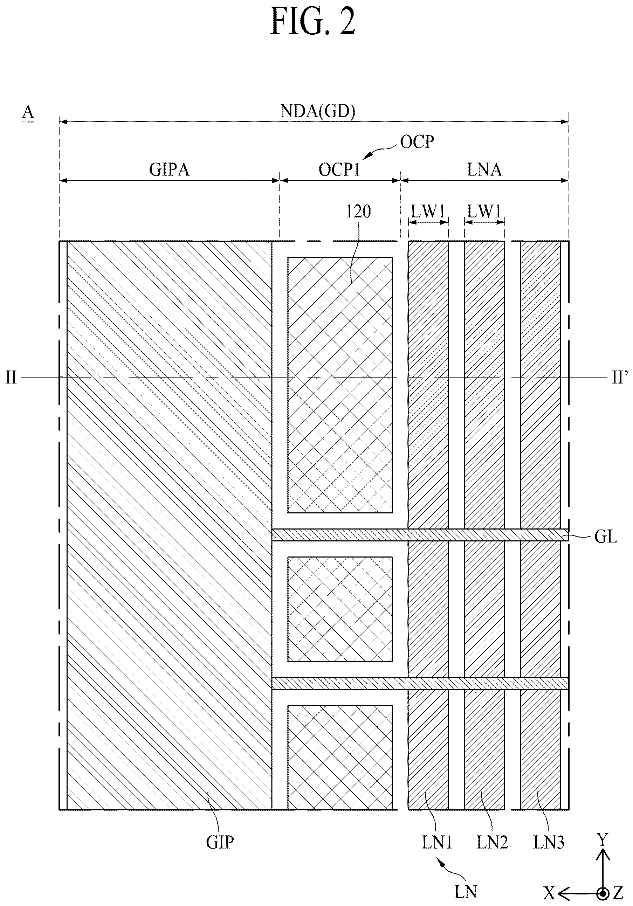

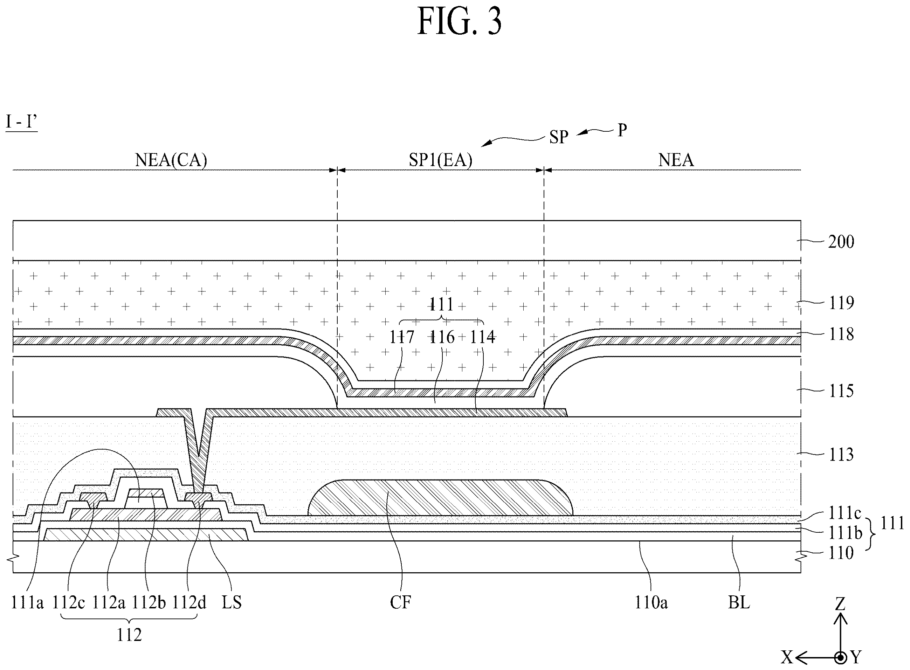

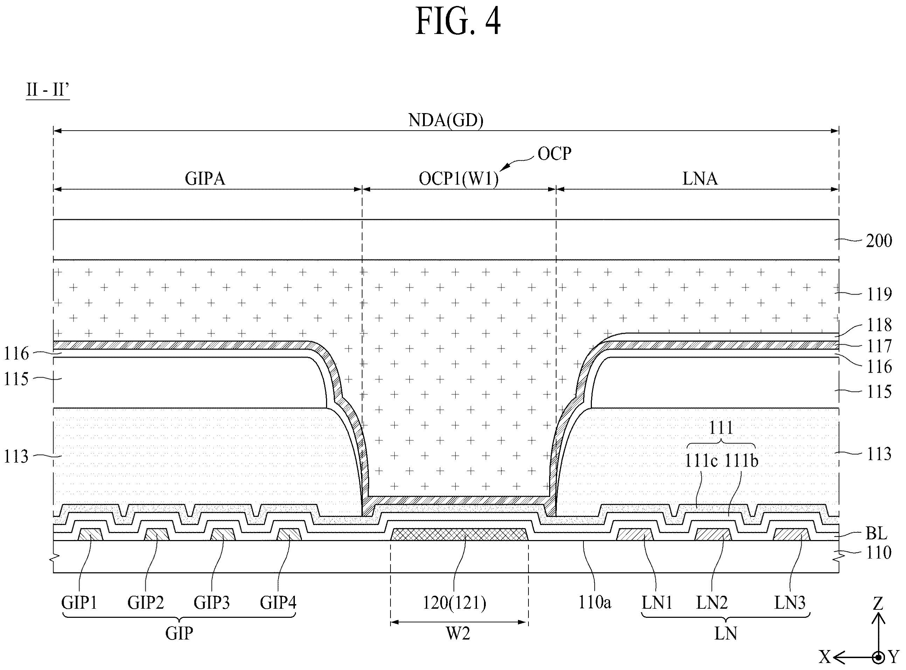

FIG. 1 is a schematic plan view of a display apparatus according to one embodiment of the present disclosure, FIG. 2 is schematic enlarged view of part A of FIG. 1 according to one embodiment of the present disclosure, FIG. 3 is a schematic cross-sectional view of the line I-I' shown in FIG. 1 according to one embodiment of the present disclosure, and FIG. 4 is a schematic cross-sectional view of the line II-II' shown in FIG. 2 according to one embodiment of the present disclosure.

Hereinafter, a first direction (Y-axis direction) represents a vertical direction based on FIG. 1, a second direction (X-axis direction) represents a horizontal direction based on FIG. 1, and a third direction (Z-axis direction) represents a thickness direction of the display apparatus 100. The first direction (Y-axis direction) may be a direction parallel to a data line. The second direction (X-axis direction) may be a direction parallel to a gate line GL (shown in FIG. 2).

Referring to FIG. 1, the display apparatus 100 according to one embodiment of the present disclosure may include a display panel having a gate driver GD. The display panel may include a substrate 110 and an opposing substrate 200 (shown in FIG. 3) bonded to each other.

The substrate 110 according to one example may include a display area DA in which a plurality of pixels P having a plurality of subpixels SP are arranged, and a non-display area NDA around the display area DA.

The display apparatus 100 according to one embodiment of the present disclosure may include a cathode electrode 117, an organic layer 116 (or an organic light-emitting layer 116), an organic layer shielding portion OCP, and a low-reflection structure 120.

The cathode electrode 117 is placed on the substrate 110 and may be provided in a portion of the non-display area NDA and the display area DA. According to one example, the cathode electrode 117 may be provided in the portion of the non-display area NDA and the display area DA by extending from the display area DA to the non-display area NDA. Accordingly, the cathode electrode 117 may be arranged on most of the substrate 110.

The organic layer 116 (or organic light-emitting layer 116) may be disposed under the cathode electrode 117. Therefore, like the cathode electrode 117, the organic layer 116 (or organic light-emitting layer 116) may be disposed to extend from the display area DA to the non-display area NDA. In the display apparatus 100 according to one embodiment of the present disclosure, the organic layer (or the organic light-emitting layer 116) and the cathode electrode 117 are formed on the substrate 110 without a separate mask, so that each of the organic layer (or the organic light-emitting layer 116) and the cathode electrode 117 can be arranged to extend from the display area DA to the non-display area NDA of the substrate 110. Due to this, the display apparatus 100 according to one embodiment of the present disclosure can not only have a simplified process, but also have a reduced manufacturing cost. As a result, the organic layer 116 (or the organic light-emitting layer 116) can be provided on the part of the non-display area NDA and the display area DA, such as the cathode electrode 117, and thus can be formed on most of the substrate 110.

In the display apparatus 100 according to one embodiment of the present disclosure, the organic layer 116 may be an organic light-emitting layer 116, but is not limited thereto, and may also mean another organic layer that is arranged in the display area DA and the non-display area NDA and can serve as a moisture and oxygen permeation path. For example, another organic layer may be a planarization layer 113 made of an organic material. In this case, both the organic light-emitting layer 116 and the planarization layer 113 may be included in the organic layer.

The organic layer shielding portion OCP may be provided in the non-display area NDA. According to one example, the organic layer shielding portion OCP may mean an area where the organic layer 116 (or the organic light-emitting layer 116) is disconnected. That is, the organic layer shielding portion OCP is a portion of the non-display area NDA that lacks the organic layer 116. The organic layer shielding portion OCP can be provided in the non-display area NDA by removing a portion of the organic layer 116 (or the organic light-emitting layer 116) provided in the non-display area NDA by patterning (or etching). The display apparatus 100 according to one embodiment of the present disclosure may have the organic layer shielding portion OCP provided in the non-display area NDA, thereby reducing or preventing moisture and oxygen permeation through the organic layer. The organic layer shield portion OCP according to one example may include a first organic layer shield portion OCP1 (shown in FIG. 2) provided in a side non-display area (or a gate driver GD) and a second organic layer shield portion OCP2 (shown in FIG. 1) provided in a bottom non-display area. The side non-display area may refer to a non-display area NDA located on a left and/or a right of the display area DA with reference to FIG. 1. The bottom non-display area may refer to a non-display area NDA located below the display area DA with reference to FIG. 1.

The low-reflection structure 120 is intended to reduce or prevent external light reflection. The low-reflection structure 120 is provided with a low-reflection material capable of reducing or preventing reflection of light, thereby reducing or preventing reflection of external light. For example, the low-reflection structure 120 can reduce or prevent external light reflection by including a low-reflectivity metal material (or a low-reflection metal material). The low-reflectivity metal material may refer to a metal material having a lower reflectivity than the cathode electrode 117. For example, when a reflectivity of the cathode electrode is 76%, a reflectivity of the low-reflectivity metal material may be 7% or less. The low-reflectivity metal material (or low-reflection metal material) may be at least one of copper (Cu), molybdenum titanium (MoTi), and tungsten oxide (WOx). Accordingly, the low-reflection structure 120 may be provided to include at least one of Cu, MoTi, and WOx. However, the present disclosure is not limited thereto, and the low-reflection structure 120 may be provided to include an organic material as long as it can reduce or prevent reflection of light.

The low-reflection structure 120 may be provided to overlap at least a portion of the organic layer shielding portion OCP. For example, the low-reflection structure 120 may be provided to overlap at least a portion of the organic layer shielding portion OCP between the cathode electrode 117 and the substrate 110. As described above, the cathode electrode 117 may be arranged to extend to the non-display area NDA, and the cathode electrode 117 may be arranged close to the substrate 110 (or an upper surface of the substrate 110) due to the organic layer shielding portion OCP. If the cathode electrode 117 is arranged close to the substrate 110 (or the upper surface of the substrate 110), the external light reflection (or external light reflectance) by the cathode electrode 117 may increase, and thus a visibility of an image may deteriorate.

According to one embodiment of the present disclosure, the display apparatus 100 is provided with the low-reflection structure 120 having a reflectivity that is less than a reflectivity of the cathode electrode 117 so as to overlap at least the portion of an organic layer shielding portion OCP between the cathode electrode 117 and the substrate 110, so that external light reflection by the cathode electrode 117 can be reduced or prevented.

In addition, since the display apparatus 100 according to one embodiment of the present disclosure can reduce or prevent external light reflection by the low-reflection structure 120, the visibility of the image can be improved.

Meanwhile, moisture on an outside may be formed by combining hydrogen and oxygen. According to one embodiment of the present disclosure, the display apparatus 100 is provided with the low-reflection structure 120 that includes a metal material, so that the barrier function may be improved compared to a case where the low-reflection structure is formed of a material other than a metal material (e.g., an inorganic material). Therefore, the display apparatus 100 according to one embodiment of the present disclosure can more effectively prevent hydrogen (or oxygen) from penetrating through the substrate 110 through the low-reflection structure 120 including a metal material, thereby improving reliability and lifespan.

Referring back to FIG. 1, the display apparatus 100 according to one embodiment of the present disclosure may include a source drive integrated circuit (hereinafter, referred to as "IC") 130, a flexible film 140, a circuit board 150, and a timing controller 160.

The substrate 110 may include a thin film transistor 112, and may be a transistor array substrate, a lower substrate, a base substrate, or a first substrate. The substrate 110 may be a transparent glass substrate or a transparent plastic substrate.

The opposite substrate 200 may be bonded to the substrate 110 via an adhesive member. For example, the opposing substrate 200 has a smaller size than the substrate 110 and can be bonded to the remaining portion of the substrate 110 except for the pad portion. The opposite substrate 200 may be an upper substrate, a second substrate, or an encapsulation substrate.

The gate driver GD supplies gate signals to the gate lines in accordance with the gate control signal input from the timing controller 160. When the source drive IC 130 is manufactured as a driving chip, the source drive IC 130 may be packaged in the flexible film 140 in a chip on film (COF) method or a chip on plastic (COP) method.

Pads such as power pads and data pads may be formed in a non-display area of a display panel. The flexible film 140 may include lines connecting the pads to a source drive IC 130 and lines connecting the pads to lines of the circuit board 150. The flexible film 140 may be attached to the pads by using an anisotropic conducting film, whereby the pads may be connected to the lines of the flexible film 140.

Referring to FIG. 1, the substrate 110 according to one example may include a display area DA and a non-display area NDA.

The display area DA is an area where an image is displayed, and may be a pixel array area, an active area, a pixel array unit, a display unit, or a screen. For example, the display area DA may be disposed at a central portion of the display panel.

The display area DA according to one example may include gate lines, data lines, pixel power lines, and a plurality of pixels P. Each of the plurality of pixels P may include a plurality of sub-pixels SP that may be defined by the gate lines and the data lines. Each of the plurality of sub-pixels SP may be defined as a minimum unit area in which light is actually emitted.

According to one example, at least four sub-pixels, which are provided to emit light of different colors and disposed to be adjacent to one another, among the plurality of sub-pixels SP constitute one unit pixel P. One unit pixel may include, but is not limited to, a red sub-pixel, a green sub-pixel, a blue sub-pixel, a white sub-pixel.

Each of the plurality of sub-pixels SP may include a thin film transistor 112 and an organic light emitting element connected to the thin film transistor 112. The sub-pixel may include a light emitting layer (or an organic light emitting layer) interposed between a first electrode and a second electrode.

The organic light emitting layer disposed in each of the plurality of sub-pixels SP may individually emit light of different colors or may commonly emit white light. According to one example, when the organic light emitting layer of each of the plurality of sub-pixels SP commonly emits white light, each of the red sub-pixel, the green sub-pixel and the blue sub-pixel may include a color filter CF (or a wavelength conversion member CF) for converting the white light into light of different colors. In this case, the white sub-pixel according to one example may not include a color filter. The color filter CF, according to one example, can include a red color filter, a green color filter, and a blue color filter.

In the display apparatus 100 according to one embodiment of the present disclosure, an area in which a red color filter is provided may be a red sub-pixel SP1, an area in which a green color filter is provided may be a green sub-pixel SP3, an area in which a blue color filter is provided may be a blue sub-pixel SP4, and an area in which a color filter is not provided may be a white sub-pixel SP2. In the present disclosure, the red sub-pixel SP1 may be expressed as a first sub-pixel provided to emit red light, the green sub-pixel SP3 may be expressed as a third sub-pixel configured to emit green light, the blue sub-pixel SP4 may be expressed as a fourth sub-pixel provided to emit blue light, and the white sub-pixel SP2 may be represented as a second sub-pixel provided to emit white light.

Each of the plurality of sub-pixels SP supplies a predetermined current to the organic light emitting element in accordance with a data voltage of the data line when a gate signal is input from the gate line by using the thin film transistor 112. For this reason, the light emitting layer of each of the sub-pixels may emit light with a predetermined brightness in accordance with the predetermined current.

Referring to FIG. 3, the display area DA may include a light emission area EA and a non-light emission area NEA. The light emission area EA is an area where light is emitted by the organic light emitting element layer E. The non-light emission area NEA is an area that does not transmit most of light incident from the outside.

For example, the non-light emission area NEA can be an area other than the light emission area EA from which light is emitted. In one example, the non-light emission area NEA may include a circuit area CA. The circuit area CA may include a thin film transistor 112 for driving the organic light emitting element layer 116.

Additionally, in the non-light emission area NEA, the plurality of pixels P and a plurality of lines for driving each of the plurality of pixels P can be disposed. The plurality of lines, according to one example, can include a plurality of first signal lines and a plurality of second signal lines.

The plurality of first signal lines may be extended in the second direction (X-axis direction). Each of the plurality of first signal lines may include at least one gate line GL (or scan line). The gate line GL according to an example can be electrically connected to a gate driving area GIPA (shown in FIG. 2). That is, the gate line GL is disposed in the gate driving area GIPA. In other words, the gate line GL is connected to the gate driving circuit GIP in the gate driving area GIPA and extends to the display area DA through the organic layer shielding portion OCP and the line area LNA.

The plurality of second signal lines can extend in the first direction (Y-axis direction). The plurality of second signal lines can intersect with the plurality of first signal lines. Each of the plurality of second signal lines may include a pixel power line, a plurality of data lines, and a reference line. The plurality of data lines DL can include a first data line for driving the first sub-pixel SP1, a second data line for driving the second sub-pixel SP2, a third data line for driving the third sub-pixel SP3, and a fourth data line for driving the fourth sub-pixel SP4.

Referring back to FIG. 1, the non-display area NDA is an area on which an image is not displayed, and may be a peripheral circuit area, a signal supply area, an inactive area or a bezel area. The non-display area NDA may be configured to be in the vicinity of the display area DA. That is, the non-display area NDA may be disposed to surround the display area DA.

The display apparatus 100 according to one embodiment of the present disclosure can include a pad portion PA disposed in the non-display area NDA. The pad portion PA can be for driving the plurality of pixels P. For example, the pad portion PA can supply power and/or signals for the plurality of pixels P disposed in the display area DA to output images. According to one example, the pad portion PA may be placed in the non-display area NDA (or the first non-display area NDA1) above the display area DA based on FIG. 1. Since the first non-display area is formed above the display area DA, it can be expressed in terms of an upper non-display area.

The gate driver GD supplies gate signals to the gate lines in accordance with the gate control signal input from the timing controller 160. The gate driver GD may be formed on one side of the display area DA of the display panel or on the non-display area NDA outside both sides of the display area DA in a gate driver in panel GIP method as shown in FIG. 1.

The plurality of gate drivers GD may be separately disposed on a left side of the display area DA, that is, the second non-display area and a right side of the display area DA, that is, the third non-display area. Since each of the second non-display area and the third non-display area is formed on a side of the display area DA, it can be expressed in terms of side non-display areas. According to one example, the plurality of gate drivers GD may be connected to the plurality of pixels P and the plurality of first signal lines for supplying signals to the plurality of pixels P. The plurality of first signal lines may include at least one signal line for supplying a signal for driving the pixel P.

The plurality of second signal lines may be extended in the first direction (Y-axis direction). The plurality of second signal lines may include a pixel power line and at least one data line to supply a data voltage to the pixel P. Each of the plurality of second signal lines may be connected to at least one of a plurality of pads, a pixel power shorting bar, and a common power shorting bar. The pixel power shorting bar and the common power shorting bar can be arranged in a fourth non-display area facing a pad portion PA based on the display area DA. Since the fourth non-display area is formed below the display area DA, it can be expressed in terms of a lower non-display area.

The pixels P are provided to overlap at least one of the first signal line or the second signal line and emit predetermined light to display an image. The light emission area EA may correspond to an area, which emits light, in the pixel P.

Referring to FIG. 3, the non-light emission area NEA may refer to an area that is provided in the display area DA and does not emit light, and may be expressed as a dead zone because it does not emit light. The dead zone according to one example may be an area in which a black matrix and/or a bank is provided, but is not limited thereto, and may refer to an area in which light is not emitted.

Referring to FIG. 2, in the display apparatus 100 according to one embodiment of the present disclosure, the gate driver GD may include a gate driving area GIPA and a line area LNA.

The gate driving area GIPA may include a circuit portion GIP. In one example, the circuit portion GIP includes a gate driver circuit for driving the plurality of pixels P in the display area DA. The circuit portion GIP disposed in the gate driving area GIPA (e.g., a first portion of the non-display area) may be arranged spaced apart from the line area LNA (e.g., a second portion of the non-display area). For example, the circuit portion GIP may be arranged spaced apart from the line area LNA with the organic layer shielding portion OCP (e.g., a third portion of the non-display area) therebetween. As shown in FIG. 4, the circuit portion GIP according to one example may include a gate driver circuit having a first circuit portion GIP1, a second circuit portion GIP2, a third circuit portion GIP3, and a fourth circuit portion GIP4. Each of the first circuit portion GIP1, the second circuit portion GIP2, the third circuit portion GIP3, and the fourth circuit portion GIP4 may be arranged to be spaced apart from each other in the second direction (X-axis direction).

For example, the fourth circuit portion GIP4 may be placed adjacent to the low-reflection structure 120 without another circuit portion between the low-reflection structure 120 and the fourth circuit portion GIP4. The third circuit portion GIP3 may be placed spaced apart from the low-reflection structure 120 with the fourth circuit portion GIP4 therebetween. The second circuit portion GIP2 can be arranged spaced apart from the fourth circuit portion GIP4 with the third circuit portion GIP3 interposed therebetween. The first circuit portion GIP1 can be arranged spaced apart from the third circuit portion GIP3 with the second circuit portion GIP2 interposed therebetween. For example, each of the first circuit portion GIP1, the second circuit portion GIP2, the third circuit portion GIP3, and the fourth circuit portion GIP4 may be a circuit stage that applies a driving signal to each of the plurality of pixels P. As shown in FIG. 2, a plurality of gate lines GL can be electrically connected in the gate driving area GIPA (shown in FIG. 2). Furthermore, the plurality of gate lines GL can extend in a second direction (X-axis direction) between a plurality of low-reflection structures 120.

The line area LNA may include a plurality of lines LN. The pad portion PA may be connected to each of a plurality of pixels P through the plurality of lines LN. Accordingly, the plurality of lines LN may transmit a driving signal applied from the pad portion PA to each of the plurality of pixels P. In one embodiment, the lines LN are considered signal lines since the lines LN transmit the driving signal applied from the pad portion PA to the pixels P. The line area LNA and the gate driving area GIPA can be provided in the gate driver GD in the non-display area NDA. Since the plurality of lines LN are arranged in the gate driver GD, they can be expressed in terms of GIP line.

As shown in FIG. 2, the plurality of lines LN according to one example may include a first line LN1, a second line LN2, and a third line LN3. Each of the first line LN1, the second line LN2, and the third line LN3 may be arranged to be spaced apart from each other in the second direction (Y-axis direction). For example, the first line LN1 may be arranged adjacent to the low-reflection structure 120 without another line between the low-reflection structure 120 and the first line LN1. The second line LN2 may be arranged spaced apart from the low-reflection structure 120 with the first line LN1 interposed between the second line LN2 and the low-reflection structure 120. The third line LN3 can be arranged spaced apart from the first line LN1 with the second line LN2 therebetween. Each of the first line LN1, the second line LN2, and the third line LN3 can extend in the first direction (Y-axis direction) along the circuit portion GIP. Each of the first line LN1, the second line LN2, and the third line LN3 can transmit a driving signal applied from the pad portion PA to each of the plurality of pixels P. As shown in FIG. 2, each of the first line LN1, the second line LN2, and the third line LN3 may be provided with a same width LW1. Accordingly, a deviation may not occur in the signals applied through each of the first line LN1, the second line LN2, and the third line LN3.

Referring to FIG. 2, in the display apparatus 100 according to one embodiment of the present disclosure, the low-reflection structure 120 may be placed between the gate driving area GIPA and the line area LNA. Accordingly, the low-reflection structure 120 can reduce or prevent external light from being reflected in the organic layer shielding portion OCP between the gate driving area GIPA and the line area LNA.

Meanwhile, as shown in FIG. 2, the low-reflection structure 120 may be provided so as not to overlap with the gate line GL. That is, the low-reflection structure 120 is non-overlapping with the gate line GL in a plane view of the display device. As described above, since the low-reflection structure 120 may be made of a metal material, if the low-reflection structure 120 overlaps with the gate line GL, it may interfere with a signal applied through the gate line GL. Accordingly, the display apparatus 100 according to one embodiment of the present disclosure is provided such that the low-reflection structure 120 is non-overlapping with the gate line GL, so that it does not interfere with the signal of the gate line GL, and thus, driving failure of the plurality of pixels P can be prevented.

Hereinafter, with reference to FIG. 3, the structure of each of the plurality of sub-pixels SP will be described in detail.

Referring to FIG. 3, the display apparatus 100 according to one embodiment of the present disclosure can include a buffer layer BL, a plurality of inorganic films 111, a thin film transistor 112, a color filter CF, a planarization layer 113, a pixel electrode 114, a bank 115, an organic light emitting layer 116, a cathode electrode 117, an encapsulation layer 118, and a filling layer 119.

Each of the subpixels SP according to one embodiment may include the plurality of inorganic films 111 provided on an upper surface of the buffer layer BL, including a gate insulating layer 111a, an interlayer insulating layer 111b, and a passivation layer 111c.

Also, each of the subpixels SP may include a color filter CF provided on the plurality of inorganic films 111, a planarization layer 113 provided on the color filter CF. The pixel electrode 114 can be placed on the planarization layer 113.

Each of the subpixels SP may further include a bank 115 covering one edge of the pixel electrode 114, an organic light-emitting layer 116 on the pixel electrode 114 and the bank 115, and a cathode electrode 117 on the organic light-emitting layer 116. The encapsulation layer 118 may be placed on the cathode electrode 117, and the filling layer 119 may be placed on the encapsulation layer 118.

The thin film transistor 112 for driving of subpixel SP may be arranged on the plurality of inorganic films 111. The plurality of inorganic films 111 may also be expressed in terms of a circuit element layer.

The buffer layer BL may be included in the plurality of inorganic films 111 together with the gate insulating layer 111a, the interlayer insulating layer 111b, and the passivation layer 111c. The pixel electrode 114, the organic light emitting layer 116 and the cathode electrode 117 may be included in a light emitting element layer E.

The buffer layer BL may be formed between the substrate 110 and the gate insulating layer 111a to protect the thin film transistor 112 112. The buffer layer BL may be disposed on the entire surface (or front surface) of the substrate 110. The buffer layer BL may serve to block diffusion of a material contained in the substrate 110 into a transistor layer during a high temperature process of a manufacturing process of the thin film transistor 112.

The thin film transistor 112 (or a drive transistor) according to an example may include an active layer 112a, a gate electrode 112b, a source electrode 112c, and a drain electrode 112d.

The active layer 112a may include a channel area, a drain area and a source area, which are formed in a thin film transistor area of a circuit area CA of the subpixel SP. The drain area and the source area may be spaced apart from each other with the channel area interposed therebetween.

The active layer 112a may be formed of a semiconductor material based on any one of amorphous silicon, polycrystalline silicon, oxide and organic material.

The gate insulating layer 111a may be formed on the channel area of the active layer 112a. As an example, the gate insulating layer 111a may be formed in an island shape only on the channel area of the active layer 112a or may be formed on the entire front surface of the substrate 110 or buffer layer BL including the active layer 112a.

The gate electrode 112b may be formed on the gate insulating layer 111a to overlap the channel area of the active layer 112a.

The interlayer insulating layer 111b can be formed to partially overlap the gate electrode 112b and the drain area and source area of the active layer 112a. The interlayer insulating layer 111b may be formed over the entire light emission area where light is emitted, as in FIG. 3, in the circuit area CA and the subpixel SP.

The source electrode 112c may be electrically connected to the source area of the active layer 112a through a source contact hole provided in the interlayer insulating layer overlapped with the source area of the active layer 112a.

The drain electrode 112d may be electrically connected to the drain area of the active layer 112a through a drain contact hole provided in the interlayer insulating layer overlapped with the drain area of the active layer 112a.

The drain electrode 112d and the source electrode 112c may be made of the same metal material. For example, each of the drain electrode 112d and the source electrode 112c may be made of a single metal layer, a single layer of an alloy or a multi-layer of two or more layers, which is the same as or different from that of the gate electrode 112b.

Additionally, the thin film transistor provided in the pixel area may have a characteristic in which the threshold voltage is shifted by light. To prevent this, the display panel or the substrate 110 may further include a light-shielding layer LS provided under the active layer 112a of at least one of the thin film transistor 112, a first switching thin film transistor, and a second switching thin film transistor.

The light-shielding layer LS is provided between the substrate 110 and the active layer 112a to block light incident on the active layer 112a through the substrate 110, thereby minimizing changes in the threshold voltage of the transistor caused by external light. In addition, the light shielding layer LS may be provided between the substrate 110 and the active layer 112a to prevent the thin film transistor 112 from being visible to the user.

The passivation layer 111c may be provided on the substrate 110 to cover the pixel area. The passivation layer 111c covers a drain electrode 112d, a source electrode 112c and a gate electrode 112b of the thin film transistor 112, and the buffer layer BL.

The color filter CF may be placed on the passivation layer 111c. For example, the color filter CF may be placed between the plurality of inorganic films 111 and the planarization layer 113. The color filter CF may include a red color filter arranged in the red subpixel SP1, a green color filter arranged in the green subpixel SP3, and a blue color filter arranged in the blue subpixel SP4. Since the white subpixel SP2 is provided to emit white light, it may not include the color filter.

The planarization layer 113 may be provided on the substrate 110 to cover the passivation layer 111c and the color filter CF. According to one example, the planarization layer 113 may be placed between the substrate 110 and the pixel electrode 114. The planarization layer 113 may be formed in the entire circuit area CA in which the thin film transistor 112 is disposed and the entire light emission area EA. In addition, the planarization layer 113 may be formed in the other non-display area NDA except a pad area PA of the non-display area NDA and the entire display area DA. For example, the planarization layer 113 may include an extension portion (or an enlarged portion) extended or enlarged from the display area DA to the other non-display area NDA except the pad area PA. Therefore, the planarization layer 113 may have a size relatively wider than that of the display area DA.

The planarization layer 113 according to one example may be formed to have a relatively thick thickness, thereby providing a flat surface on the display area DA and the non-display area NDA. For example, the planarization layer 113 may be made of an organic material such as photo acryl, benzocyclobutene, polyimide and fluorine resin.

On the other hand, an upper surface of the planarization layer 113 can be provided flatly. Accordingly, the pixel electrode 114 on the planarization layer 113 can also be provided flatly, and the organic light emitting layer 116 and the cathode electrode 117 formed thereon can also be provided flatly. Since the pixel electrode 114, the organic light emitting layer 116, the cathode electrode 117, that is, the light emitting element layer E is provided to be flat in the light emission area EA, a thickness of each of the pixel electrode 114, the organic light emitting layer 116 and the cathode electrode 117 in the light emission area EA may be uniformly formed. Therefore, the organic light emitting layer 116 may be uniformly emitted without deviation in the light emission area EA.

The pixel electrode 114 can be formed on the planarization layer 113. Although not shown, the pixel electrode 114 may be connected to a drain electrode 112d or a source electrode 112c of the thin film transistor 112 through a contact hole passing through the planarization layer 113 and the passivation layer 111c. An edge portions on both sides of the pixel electrode 114 may be covered by the bank 115. The pixel electrode 114 may be made of at least one of a transparent metal material or a semi-transmissive metal material.

Because the display apparatus 100 according to an embodiment of the present disclosure is configured as the bottom emission type, the pixel electrode 114 may be formed of a transparent conductive material (or TCO), such as indium tin oxide (ITO) or indium zinc oxide (IZO) capable of transmitting light, or a semi-transmissive conductive material such as magnesium (Mg), silver (Ag), or an alloy of Mg and Ag.

Meanwhile, the material constituting the pixel electrode 114 may include MoTi. The pixel electrode 114 may be a first electrode or an anode electrode.

The bank 115 may be an area, which does not emit light, and can be placed adjacent to the light emission area EA of each of the plurality of sub-pixels SP. For example, the bank 115 may be disposed in the non-light emission area NEA. The bank 115 may be formed to cover a portion where the edge of the pixel electrode 114. Accordingly, the bank 115 may prevent the pixel electrode 114 and the cathode electrode 117 in the edge of the pixel electrode 114. The exposed portion of the pixel electrode 114 that is not covered by the bank 115 may be included in the light emitting portion (or light emission area EA).

After the bank 115 is formed, an organic light emitting layer 116 may be formed to cover the pixel electrode 114 and the bank 115. Thus, the bank 115 may be partially provided between the pixel electrode 114 and the organic light emitting layer 116. The bank 115 can be expressed in terms of a pixel definition films. The bank 115 according to one example may comprise organic material and/or inorganic material.

The organic light emitting layer 116 may be formed on the pixel electrode 114 and the bank 115. The organic light emitting layer 116 can be placed under the cathode electrode 117. According to one example, the organic light emitting layer 116 may be disposed in the light emission area EA and the non-light emission area NEA. The organic light emitting layer 116 may be provided between the pixel electrode 114 and the cathode electrode 117. Thus, when a voltage is applied to each of the pixel electrode 114 and the cathode electrode 117, an electric field is formed between the pixel electrode 114 and the cathode electrode 117. Therefore, the organic light emitting layer 116 may emit light. The organic light emitting layer 116 may be formed of a plurality of subpixels SP and a common layer provided on the bank 115.

The organic light emitting layer 116 according to one embodiment may be provided to emit white light. The organic light emitting layer 116 may include a plurality of stacks which emit lights of different colors. For example, the organic light emitting layer 116 may include a first stack, a second stack, and a charge generating layer (CGL) provided between the first stack and the second stack. The light emitting layer may be provided to emit the white light, and thus, each of the plurality of subpixels SP may include a color filter CF suitable for a corresponding color.

The first stack may be provided on the pixel electrode 114 and may be implemented a structure where a hole injection layer (HIL), a hole transport layer (HTL), an emission layer (EML(B)), and an electron transport layer (ETL) are sequentially stacked.

The charge generating layer may supply an electric charge to the first stack and the second stack. The charge generating layer may include an N-type charge generating layer for supplying an electron to the first stack and a P-type charge generating layer for supplying a hole to the second stack. The N-type charge generating layer may include a metal material as a dopant.

The second stack may be provided on the first stack and may be implemented in a structure where a hole transport layer (HTL), a yellow-green (YG) emission layer (EML(YG)), and an electron injection layer (EIL) are sequentially stacked.

In the display apparatus 100 according to an embodiment of the present disclosure, because the organic light emitting layer 116 is provided as a common layer, the first stack, the charge generating layer, and the second stack may be arranged all over the plurality of subpixels SP. The organic light emitting layer 116, according to another example, may be provided in a three-stacked structure or a four-stacked structure, depending on the number of stacks stacked.

The cathode electrode 117 may be formed on the organic light emitting layer 116. The cathode electrode 117 may be arranged in the non-display area NDA (or a part of the non-display area NDA) and the display area DA. In the display area DA, the cathode electrode 117 may be arranged in the light emission area EA and the non-light emission area NEA. That is, the cathode electrode 117 may be arranged to cover the entire display area DA. As a result, the cathode electrode 117 may be arranged to have a size larger than the display area DA and smaller than the substrate 110. Accordingly, the cathode electrode 117 can be placed in the non-display area NDA (or the part of the non-display area NDA) and the display area DA.

The cathode electrode 117 according to one example may include a metal material. The cathode electrode 117 may reflect the light emitted from the organic light emitting layer 116 in the plurality of subpixels SP toward a lower surface of the substrate 110. Therefore, the display apparatus 100 according to one embodiment of the present disclosure may be implemented as a bottom emission type display apparatus.

The display apparatus 100 according to one embodiment of the present disclosure is a bottom emission type and has to reflect light emitted from the light emitting layer 122 toward the substrate 110, and thus the cathode electrode 117 may be made of a metal material having high reflectance. The cathode electrode 117 according to one example may be formed of a metal material having high reflectance such as silver (Ag), aluminum (Al), a stacked structure (Ti/Al/Ti) of aluminum and titanium, a stacked structure (ITO/Al/ITO) of aluminum and ITO, an Ag alloy and a stacked structure (ITO/Ag alloy/ITO) of Ag alloy and ITO. The Ag alloy may be an alloy such as silver (Ag), palladium (Pd) and copper (Cu). The cathode electrode 117 may be expressed as terms such as a second electrode, an opposing electrode and a reflective electrode.

The encapsulation layer 118 is formed on the cathode electrode 117. The encapsulation layer 118 serves to prevent oxygen or moisture from penetrating into the organic light emitting layer 116 and the cathode electrode 117. The encapsulation layer 118 can comprise a plurality of layers including at least one inorganic film and at least one organic film.

On the other hand, as shown in FIG. 3, the encapsulation layer 118 can be disposed not only in the light emission area EA but also in the non-light emission area NEA. The encapsulation layer 118 can be disposed between the cathode electrode 117 and the opposing substrate 200.

The filling layer 119 can be formed on the encapsulation layer 118. The filling layer 119 can be positioned to fill a gap between the substrate 110 and the opposing substrate 200, thereby supporting the substrate 110 and the opposing substrate 200. Therefore, the filling layer 119 can prevent the substrate 110 and the opposing substrate 200 from being easily deformed by external force.

The filling layer 119 is provided to be placed between the organic light-emitting layer 116 formed on the substrate 110 and the opposing substrate 200, thereby preventing external moisture and/or oxygen penetrating through the opposing substrate 200 from reaching the organic light-emitting layer 116. That is, the filling layer 119 may have a barrier function to prevent moisture penetration. The filling layer 119 may further contain an absorbent material for absorbing moisture or oxygen to enhance the moisture penetration prevention effect. For example, the absorbent material may be a getter.

Meanwhile, the filling layer 119 may include a thermosetting transparent adhesive or a photocurable transparent adhesive. In this case, the filling layer 119 may be used to bond the substrate 110 and the opposing substrate 200. Therefore, the bonding strength between the substrate 110 and the opposing substrate 200 may be further improved by the filling layer 119.

Referring to FIG. 4, in the display apparatus 100 according to one embodiment of the present disclosure, the low-reflection structure 120 may be in contact (e.g., direct contact) with an upper surface 110a of the substrate 110. In one embodiment, the low-reflection structure 120 includes a low-reflection member 121 as shown in FIG. 4. Since the low-reflection structure 120 is intended to reduce or prevent external light reflection, the effect of reducing external light reflection may be greater when it is positioned closest to the substrate 110. Accordingly, the display apparatus 100 according to one embodiment of the present disclosure may have a structural feature in which the low-reflection structure 120 disposed on the organic layer shielding portion OCP is in direct contact with a surface of the substrate 110 such as the upper surface 110a of the substrate 110.

The low-reflection structure 120 is formed together with the plurality of lines LN when they are formed in the line area LNA, so that it can come into contact with an upper surface 110a of the substrate 110. Accordingly, the display apparatus 100 according to one embodiment of the present disclosure can form the low-reflection structure 120 on the substrate 110 by utilizing a process line of the substrate 110, for example, a process of forming the light-shielding layer LS, and/or a process of forming the plurality of lines LN in the line area LNA, so that not only can the low-reflection structure 120 be provided without additional cost, but also production energy can be reduced through process optimization. In one embodiment, the low-reflection structure 120 is made of a same material as the lines LN.

Meanwhile, in the display apparatus 100 according to one embodiment of the present disclosure, a width W2 of the low-reflection structure 120 may be provided to be narrower than (e.g., less than) a width W1 of the organic layer shielding portion OCP. For example, as shown in FIG. 4, the low-reflection structure 120 may be provided with a width that does not overlap with the planarization layer 113 in the third direction (Z-axis direction). That is, the low-reflection structure 120 is non-overlapping with the planarization layer 113 in the non-display area NDA. Accordingly, the low-reflection structure 120 can be positioned at a sufficient distance from each of the first line LN1 of the line area LN and the fourth circuit section GIP4 of the gate driving area GIPA. Therefore, the low-reflection structure 120 can avoid interfering with the signal of the first line LN1 and the driving signal of the fourth circuit section GIP4.

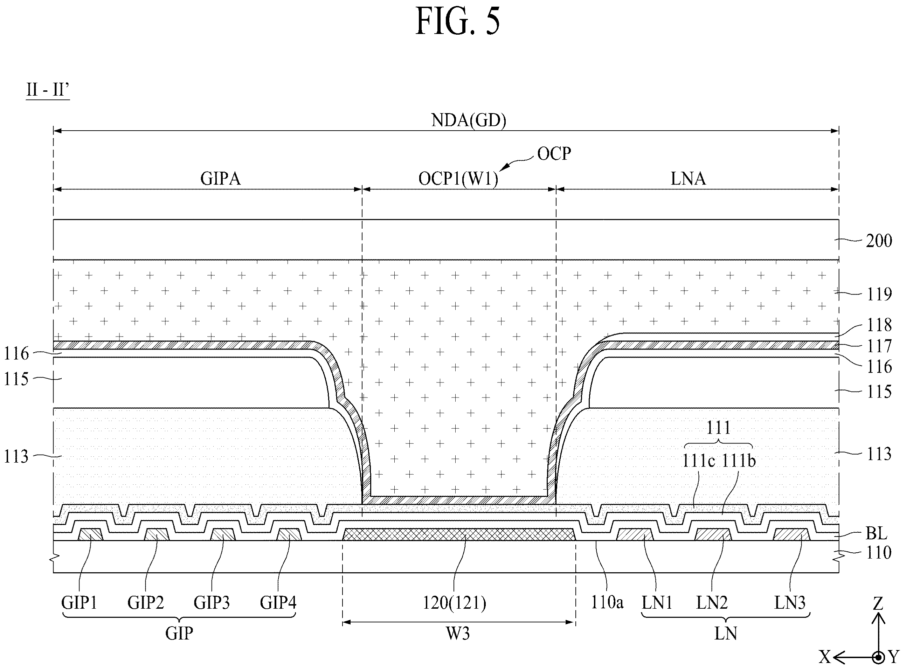

FIG. 5 is a drawing showing another example of FIG. 4 according to one embodiment.

Referring to FIG. 5, another example of the display apparatus 100 according to one embodiment of the present disclosure may be provided such that a width W3 of the low-reflection structure 120 is wider than a width W1 of the organic layer shielding portion OCP. For example, as shown in FIG. 5, some of both sides of the low-reflection structure 120 may be provided to overlap with the planarization layer 113 in the third direction (Z-axis direction). That is, at least one end of the of the low-reflection structure 120 overlaps the planarization layer 113. Accordingly, the low-reflection structure 120 can cover the entirety (or the entire area) of the organic layer shielding portion OCP. Therefore, another example of the display apparatus 100 according to one embodiment of the present disclosure can further improve an effect of reducing external light reflection compared to the case where the low-reflection structure 120 covers only a part (or a part of an area) of the organic layer shielding portion OCP.

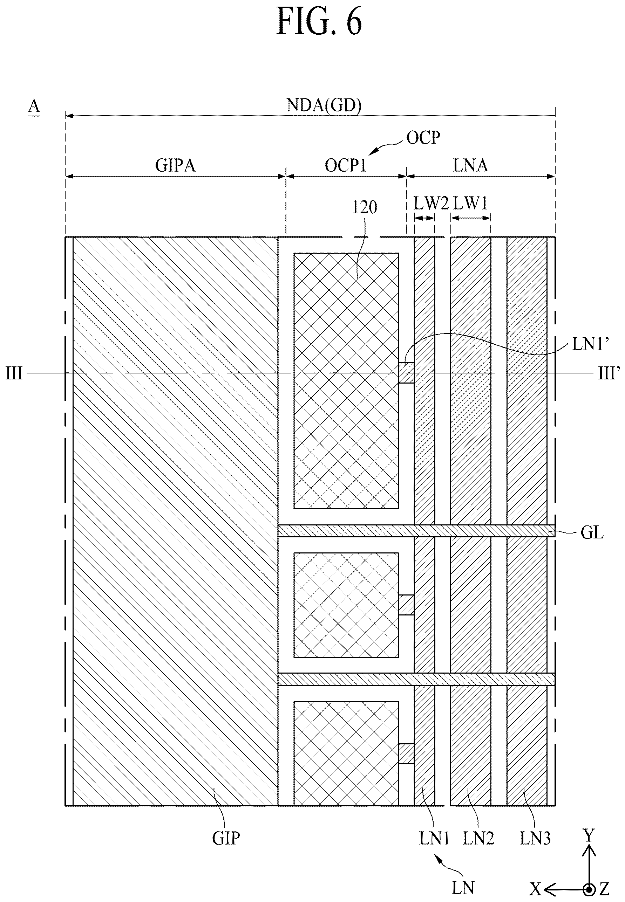

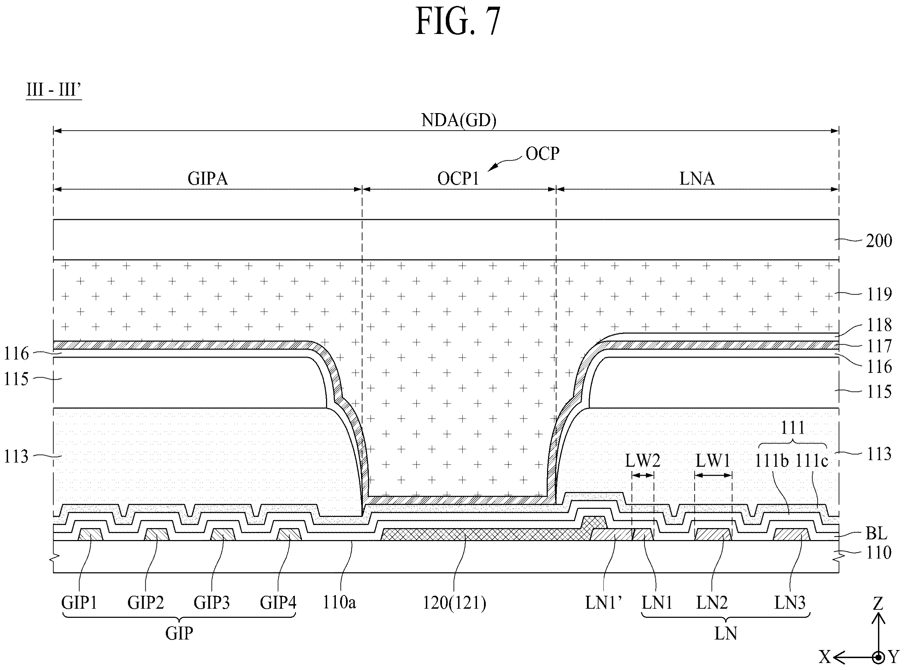

FIG. 6 is a plan view showing a display apparatus according to the second embodiment of the present disclosure, and FIG. 7 is a schematic cross-sectional view of the line III-III' shown in FIG. 6 according to one embodiment.

Referring to FIG. 6, the display apparatus 100 according to the second embodiment of the present disclosure is the same as the display apparatus according to FIG. 1 described above, except that the low-reflection structure 120 and the first line LN1 are connected. Accordingly, the same reference numerals are assigned to the same components, and only the different components will be described below.

In the case of the display apparatus according to FIG. 1, the low-reflection structure 120 and the first line LN1 of the line area LNA may be arranged to be spaced apart from each other. That is, the low-reflection structure 120 and the first line LN1 may be provided so as not to be electrically connected to each other. Accordingly, in the case of the display apparatus according to FIG. 1, the low-reflection structure 120 may not interfere with the signal of the first line LN1, so that a driving failure for outputting an image may be prevented.

In contrast, in the case of the display apparatus according to FIG. 6, the low-reflection structure 120 can be connected to the first line LN1. For example, as shown in FIG. 7, the first line LN1 may include a portion LN1' that extends from a side of the first line LN1 toward the organic layer shielding portion OCP, and one end of the low-reflection structure 120 may be brought into contact with an upper side of the portion LN1' of the extended first line LN1 (or the extended first line LN1'). Accordingly, the low-reflection structure 120 and the first line LN1 can be electrically connected to each other. However, this is not limited to the present disclosure, and the low-reflection structure 120 and the first line LN1 can be formed integrally (or as a single metal layer) with a same material on a same layer. Meanwhile, the first line LN1 extended (or expanded) toward the organic layer shielding portion OCP can be indicated by the drawing symbol LN1'.

Therefore, in the display apparatus according to FIG. 6, a width LW2 of the first line LN1 can be narrower than (e.g., less than) a width LW1 (shown in FIG. 2) of the first line LN1 of the display apparatus according to FIG. 1, since the low-reflection structure 120 including the metal material functions as an auxiliary line. Since a width of the second line LN2 is the same as a width LW1 of the first line LN1 of the display apparatus according to FIG. 1, the width LW2 of the first line LN1 of the display apparatus according to FIG. 6 may be narrower than the width LW1 of the second line LN2.

As a result, the display apparatus 100 according to the second embodiment of the present disclosure is provided such that the low-reflective structure 120 including a metal material is electrically connected to the line LN (e.g., the first line LN1) of the non-display area NDA (or bezel), so that a width of the line LN (e.g., the first line LN1) can be reduced, and thus a size of the non-display area NDA (or bezel) can be reduced.

Meanwhile, in the display apparatus according to the first embodiment and the second embodiment of the present disclosure, the low-reflection structure 120 may be placed on the upper surface 110a of the substrate 110. Accordingly, the display apparatus according to the first embodiment and the second embodiment of the present specification can be distinguished from an embodiment (another embodiment) in which the low-reflection structure 120 is disposed on another layer (e.g., the buffer layer BL and the interlayer insulating layer 111b), and thus can be indicated by the drawing reference numeral 121.

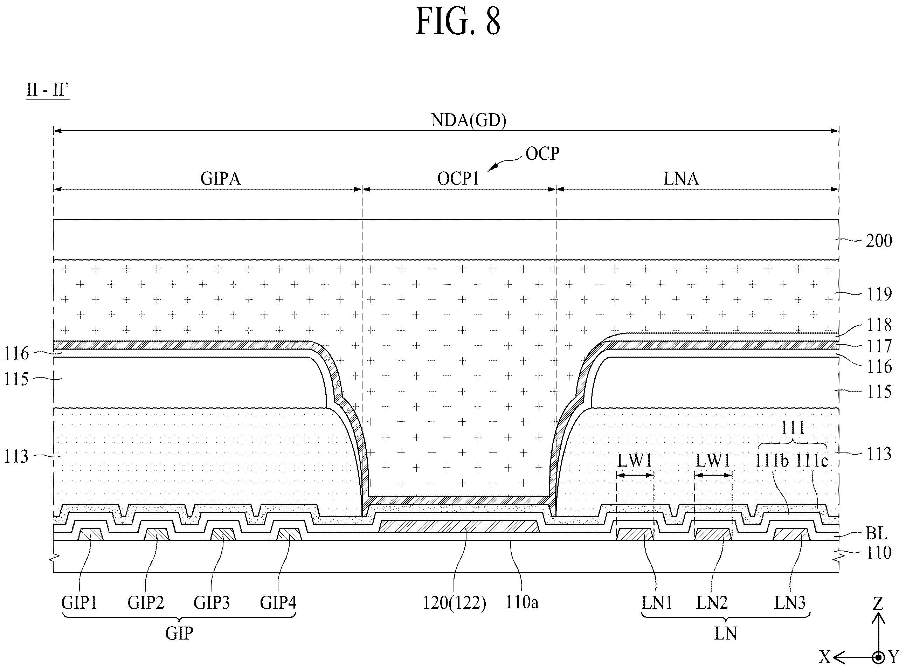

FIG. 8 is a drawing showing a display apparatus according to the third embodiment of the present disclosure, and is a modified example of FIG. 4.

Referring to FIG. 8, the display apparatus 100 according to the third embodiment of the present disclosure is a same as the display apparatus according to FIG. 1 described above, except that the low-reflection structure 120 is provided with a same layer and a same material as the active layer 112a of the thin film transistor 112. Accordingly, the same reference numerals are assigned to the same components, and only the different components will be described below.

In the case of the display apparatus according to FIG. 1, the low-reflection structure 120 can be formed together with the plurality of lines LN (or the light-shielding layer LS) in the line area LNA. Accordingly, in the case of the display apparatus according to FIG. 1, the low-reflection structure 120 can be placed on the upper surface 110a of the substrate 110. In addition, in the case of the display apparatus according to FIG. 1, since the organic layer shielding portion OCP can be formed by utilizing a process line for forming the plurality of lines LN, production energy can be reduced.

In contrast, in the case of the display apparatus according to FIG. 8, the low-reflection structure 120 may be formed together with the organic layer shielding portion OCP when the active layer 112a of the thin film transistor 112 is formed. Accordingly, as shown in FIG. 8, the low-reflection structure 120 may be placed between the buffer layer BL and the interlayer insulating layer 111b. Here, the buffer layer BL is a layer positioned between the cathode electrode 117 and the substrate 110, and the interlayer insulating layer 111b is a layer positioned between the buffer layer BL and the cathode electrode 117. Accordingly, the display apparatus 100 according to the third embodiment of the present disclosure can be formed on the organic layer shielding portion OCP by utilizing the process line in which the low-reflection structure 120 forms the active layer 112a, so that production energy can be reduced.

Meanwhile, in the display apparatus 100 according to the third embodiment of the present disclosure, the low-reflection structure 120 can be distinguished from the embodiment in which the low-reflection structure 120 is disposed on the upper surface 110a of the substrate 110 in that it is disposed between the buffer layer BL and the interlayer insulating layer 111b, and thus can be indicated by the drawing reference numeral 122.

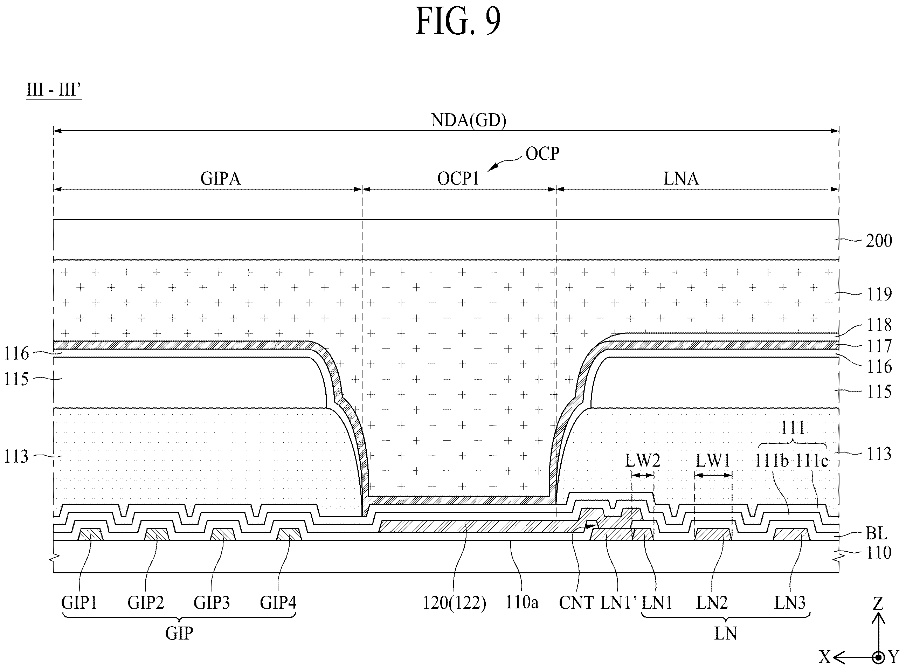

FIG. 9 is a drawing showing another example of FIG. 8, which is a modified example of FIG. 7 according to one embodiment.

Referring to FIG. 9, another example of a display apparatus 100 according to the third embodiment of the present disclosure is a same as the display apparatus according to FIG. 8 described above, except that the low-reflection structure 120 and the first line LN1 are connected. Accordingly, the same reference numerals are assigned to the same components, and only the different components will be described below.

In the case of the display apparatus according to FIG. 8, the low-reflection structure 120 and the first line LN1 of the line area LNA may be arranged to be spaced apart from each other in different layers. That is, the low-reflection structure 120 and the first line LN1 of the line area LNA may be provided so as not to be electrically connected to each other. Accordingly, in the case of the display apparatus according to FIG. 8, the low-reflection structure 120 may not interfere with a signal of the first line LN1, so that a driving failure for outputting an image may be prevented.

In contrast, in the case of the display apparatus according to FIG. 9, the low-reflection structure 120 can be connected to the first line LN1. For example, as shown in FIG. 9, the first line LN1 is partially extended (or expanded) toward the organic layer shielding portion OCP, and one end of the low-reflection structure 120 is brought into contact with the extended first line LN1' through a contact hole CNT penetrating the buffer layer BL, so that the low-reflection structure 120 and the first line LN1 can be electrically connected to each other. Accordingly, in the display apparatus according to FIG. 9, the low-reflection structure 120 made of the same material as the active layer 112a functions as an auxiliary line, so that the width LW2 of the first line LN1 can be narrower than the width LW1 of the second line LN2.

As a result, another example of the display apparatus 100 according to the third embodiment of the present disclosure is provided such that a low-reflective structure 120 formed on the same layer as the active layer 112a and including the same material as the active layer 112a is electrically connected to the line LN (e.g., the first line LN1) of the non-display area NDA (or bezel), so that a width of the line LN (e.g., the first line LN1) can be reduced, and thus the size of the non-display area NDA (or bezel) can be reduced. Accordingly, another example of the display apparatus 100 according to the third embodiment of the present disclosure may implement a narrow bezel with a small size of the non-display area NDA.

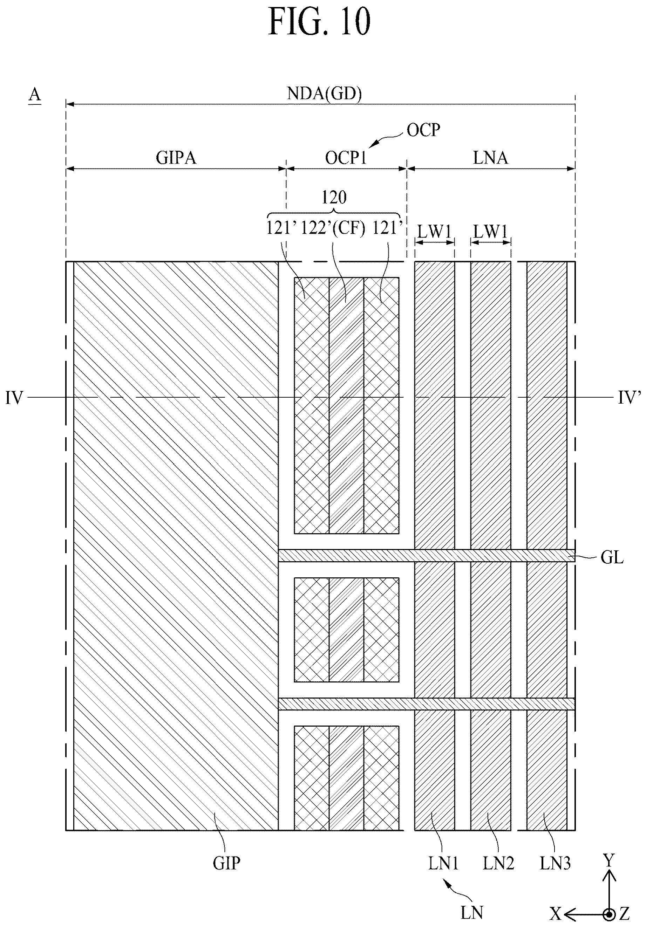

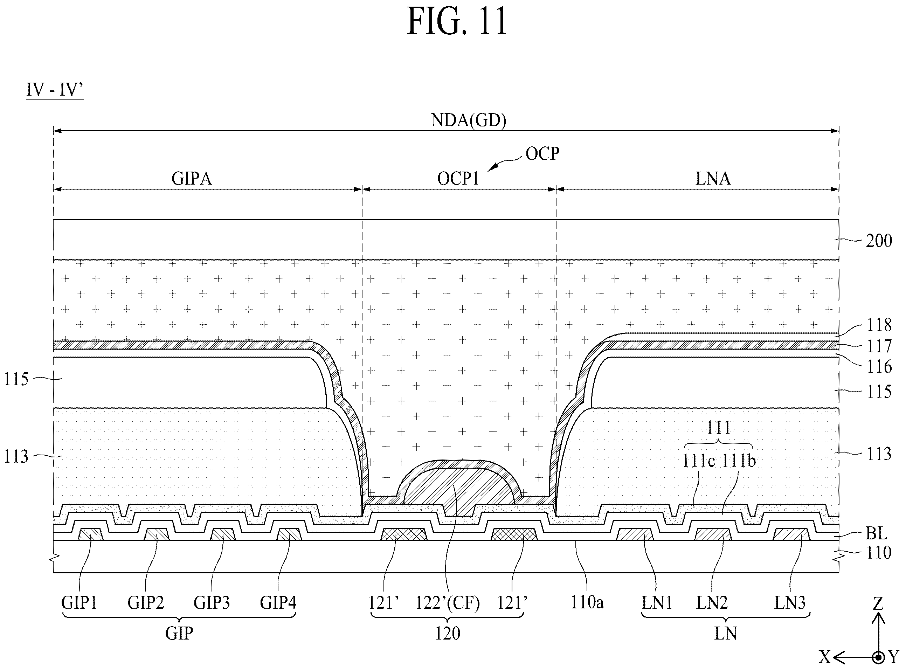

FIG. 10 is a plan view showing a display apparatus according to the fourth embodiment of the present disclosure, and FIG. 11 is a schematic cross-sectional view of line IV-IV' shown in FIG. 10 according to one embodiment.

Referring to FIG. 10, the display apparatus 100 according to the fourth embodiment of the present disclosure is the same as the display apparatus according to FIG. 1 described above, except that a structure of the low-reflection structure 120 is changed. Accordingly, the same reference numerals are assigned to the same components, and only the different components will be described below.

In the case of the display apparatus according to FIG. 1, the low-reflection structure 120 may be provided as a single layer in the organic layer shielding portion OCP to reduce or prevent external light reflection. For example, the low-reflection structure 120 may be provided as a single layer so as to be in contact with the upper surface 110a of the substrate and overlap at least a portion of the organic layer shielding portion OCP, thereby reducing or preventing external light reflection.

In contrast, in the case of the display apparatus according to FIG. 10, the low-reflection structure 120 may be provided in a plurality of layers. For example, as shown in FIG. 11, a display apparatus 100 according to the fourth embodiment of the present disclosure may include the low-reflection structure 120 including a first low-reflection member 121' and a second low-reflection member 122', and the first low-reflection member 121' and the second low-reflection member 122' may be arranged in different layers.

According to one example, the first low-reflection member 121' may be arranged on the upper surface 110a of the substrate 110 and may be provided with at least one first low-reflection member 121'. For example, as shown in FIG. 11, the first low-reflection member 121' may be arranged on the upper surface 110a of the substrate 110 and divided into two first low-reflection members 121' by the organic layer shielding portion OCP. Each of the two first low-reflection members 121' may be formed with the plurality of lines LN (or the light-shielding layers LS) and may be disposed on the upper surface 110a of the substrate 110. In addition, the two first low-reflection members 121' may include a metal material by being formed with the lines LN (or light-shielding layers LS). As shown in FIG. 11, the two first low-reflection members 121' may be disposed at an edge of the organic layer shielding portion OCP.

According to an example, the second low-reflection member 122' may be arranged in a different layer from at least one first low-reflection member 121'. For example, as shown in FIG. 11, one second low-reflection member 122' may be arranged between the passivation layer 111c and the cathode electrode 117. Accordingly, the second low-reflection member 122' may be placed on at least one first low-reflection member 121'. Thus, the second low-reflection member 122' overlaps at least one first low-reflection member 121'. However, the present invention is not limited thereto, and the second low-reflection member 122' may be placed below at least one first low-reflection member 121' if it is possible to reduce or prevent external light reflection.

The second low-reflection member 122' according to an example may include an organic material. For example, the second low-reflection member 122' may be a color filter CF. The second low-reflection member 122' may be formed together with the color filter CF and may be placed between the passivation layer 111c of the organic layer shielding portion OCP and the cathode electrode 117. In this case, the second low-reflection member 122' may be placed on the first low-reflection member 121'. Furthermore, the second low-reflection member 122' may partially overlap at least one first low-reflection member 121'. For example, as shown in FIG. 11, an edge portion of one second low-reflection member 122' may partially overlap with each of two first low-reflection members 121' (or an inner portion of each of the first low-reflection members 121'). In the above, it has been described that one second low-reflection member 122' is provided, but this is not limited to this, and at least two or more may be provided in the organic layer shielding portion OCP if it is possible to reduce or prevent external light reflection.

Meanwhile, in the display apparatus 100 according to the fourth embodiment of the present disclosure, the color filter CF provided as the second low-reflection member 122' may be a blue color filter CF. The blue color filter CF is a color filter of a different color, for example, a red color filter or a green color filter, because it has a lower external light reflectance. Accordingly, the display apparatus 100 according to the fourth embodiment of the present disclosure may have a greater effect in reducing external light reflection than when the second low-reflection member 122' is provided with the blue color filter CF compared to when the second low-reflection member 122' is provided with a color filter of a different color.

The display apparatus 100 according to the fourth embodiment of the present disclosure is provided such that a plurality of low-reflection structures 120 (e.g., a first low-reflection member 121' and a second low-reflection member 122') are arranged in different layers to cover the organic layer shielding portion OCP, thereby blocking external light incident from an outside toward the organic layer shielding portion OCP, thereby reducing or preventing external light reflection. In addition, the display apparatus 100 according to the fourth embodiment of the present disclosure is provided with the plurality of low-reflection structures 120 (e.g., the first low-reflection member 121' and the second low-reflection member 122') partially overlapping, so that external light incident from the outside toward the organic layer shielding portion OCP can be double-blocked, thereby maximizing the effect of reducing external light reflection.

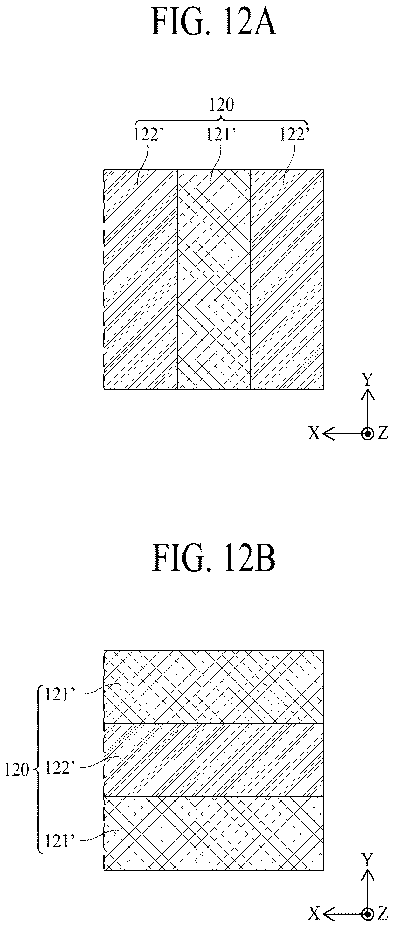

FIGS. 12A to 12E are schematic plan views showing various examples of the low-reflection structure of a display apparatus according to the fourth embodiment of the present disclosure.

FIG. 12A shows a first low-reflection member 121' and two second low-reflection members 122' having a vertical stripe shape extending in the first direction (Y-axis direction). For example, a first low-reflection member 121' including a metal material may be placed between two second low-reflection members 122' including an organic material. Accordingly, in the case of FIG. 12A, one first low-reflection member 121' and two second low-reflection members 122' arranged in a vertical stripe shape can reduce or prevent external light reflection. Meanwhile, in the case of FIG. 12A, since the first low-reflection member 121' is arranged in a different layer from the second low-reflection member 122', it can be connected to the first line LN1. Accordingly, since the first low-reflection member 121' can function as an auxiliary line, a size of the non-display area NDA (or bezel) of the display apparatus of the present disclosure can be reduced.

FIG. 12B shows two first low-reflection members 121' and one second low-reflection member 122' having a horizontal stripe shape extending in the second direction (X-axis direction). For example, one second low-reflection member 122' including an organic material may be placed between the first low-reflection member 121' including a metal material. Accordingly, in the case of FIG. 12B, one second low-reflection member 122' and two first low-reflection members 121' arranged in a horizontal stripe shape can reduce or prevent external light reflection. Meanwhile, in the case of FIG. 12B, since the first low-reflection member 121' is arranged in a horizontal direction, it can be easily connected to the first line LN1. In addition, in the case of FIG. 12B, since the plurality of first low-reflection members 121' are provided (e.g., two), an area of the auxiliary line can be expanded. Accordingly, in the case of FIG. 12B, a size of the non-display area NDA (or bezel) can be further reduced.

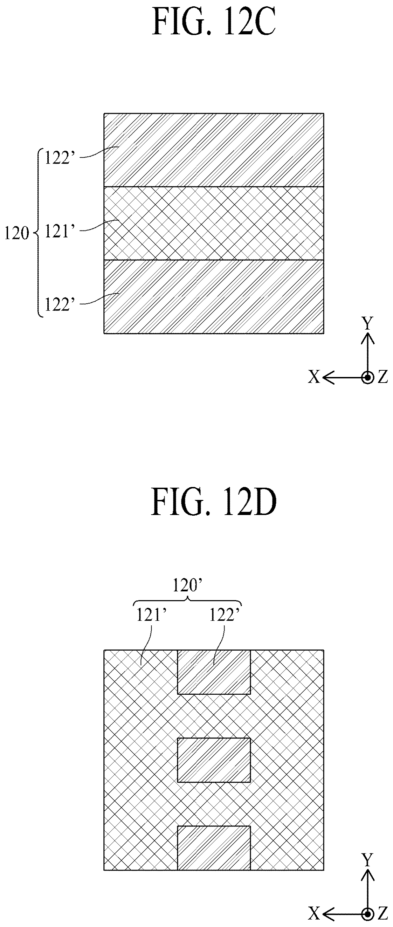

FIG. 12C shows a first low-reflection member 121' and two second low-reflection members 122' having a horizontal stripe shape extending in the second direction (X-axis direction). For example, a first low-reflection member 121' including a metal material may be placed between two second low-reflection members 122' including an organic material. Accordingly, in the case of FIG. 12C, one first low-reflection member 121' and two second low-reflection members 122' arranged in a horizontal stripe shape can reduce or prevent external light reflection. Meanwhile, in the case of FIG. 12C, since the first low-reflection member 121' is arranged in a horizontal direction, it can be easily connected to the first line LN1. Accordingly, in the case of FIG. 12C, a size of the non-display area NDA (or bezel) can be reduced.

FIG. 12D shows the first low-reflection member 121' provided in a mesh shape, and the plurality of second low-reflection members 122' have a square shape that fills holes provided in the mesh shape. For example, the first low-reflection member 121' including a metal material may be provided in a mesh shape, and the plurality of second low-reflection members 122' including an organic material may be provided in a square shape that fills holes provided in the mesh shape. Accordingly, in the case of FIG. 12D, the first low-reflection member 121' in a mesh shape and the plurality of second low-reflection members 122' in a square shape can reduce or prevent external light reflection. Meanwhile, in the case of FIG. 12D, since the first low-reflection member 121' is arranged in a mesh shape, it can be arranged on an outside compared to the second low-reflection member 122'. Accordingly, the first low-reflection member 121' can be easily connected to the first line LN1. In addition, in the case of FIG. 12d, since the first low-reflection member 121' is arranged in a mesh shape, the area of the auxiliary line can be expanded compared to the case where the first low-reflection member 121' is arranged in a stripe shape, so that a size reduction of the non-display area NDA (or bezel) can be maximized.

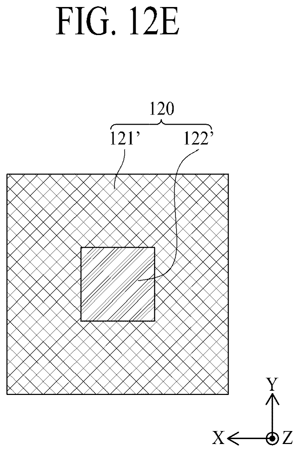

FIG. 12E shows that the first low-reflection member 121' is provided in a shape of a square ring, and the second low-reflection member 122' has a square shape that fills a hole provided in a center of the square ring. For example, the first low-reflection member 121' including a metal material may be provided in a square ring shape surrounding the second low-reflection member 122', and the second low-reflection member 122' including an organic material may be provided in a square shape filling a hole provided in the square ring shape. Accordingly, in the case of FIG. 12e, the first low-reflection member 121' in the shape of the square ring and the second low-reflection member 122' in the shape of the square can reduce or prevent external light reflection. Meanwhile, in the case of FIG. 12e, the first low-reflection member 121' is arranged in the square ring shape surrounding the second low-reflection member 122', so that it can be easily connected to the first line LN1. And, in the case of FIG. 12e, since the first low-reflection member 121' is arranged in the square ring shape, an area of the auxiliary line can be wider than in the case where the first low-reflection member 121' is arranged in the stripe shape, so that a size reduction of the non-display area NDA (or bezel) can be maximized.

As a result, the display apparatus 100 according to the present disclosure may have a structural feature in which the first low-reflection member 121' is provided in at least one of a stripe shape, a mesh shape, and a square ring shape, and the second low-reflection member 122' is provided in at least one of a stripe shape and a square shape.

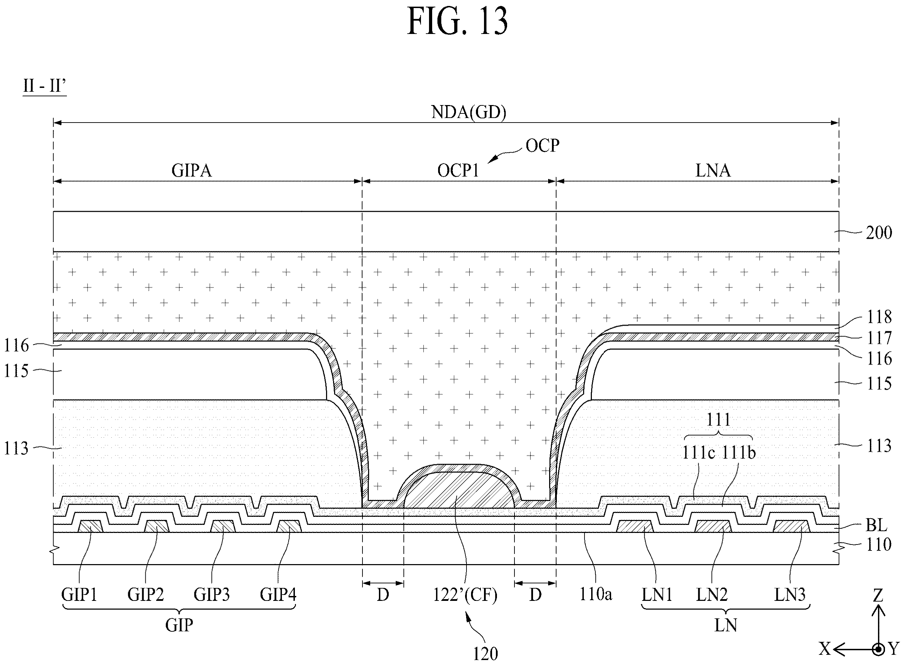

FIG. 13 is a drawing showing a display apparatus according to the fifth embodiment of the present disclosure, which is another modified example of FIG. 4.

Referring to FIG. 13, a display apparatus 100 according to the fifth embodiment of the present disclosure is the same as the display apparatus according to FIG. 1 described above, except that the low-reflection structure 120 is provided with a same layer and a same material as the color filter CF. Accordingly, the same reference numerals are assigned to the same components, and only the different components will be described below.

In the case of the display apparatus according to FIG. 1, the low-reflection structure 120 can be formed together with the plurality of lines LN (or the light-shielding layers LS) in the line area LNA. Accordingly, in the case of the display apparatus according to FIG. 1, the low-reflection structure 120 can be placed on the upper surface 110a of the substrate 110. In addition, in the case of the display apparatus according to FIG. 1, since a process line for forming the plurality of lines LN (or the light-shielding layers LS) can be used to form the organic layer shielding portion OCP, production energy can be reduced.

In contrast, in the case of the display apparatus according to FIG. 13, the low-reflection structure 120 may be formed together with the organic layer shielding portion OCP when the color filter CF of the plurality of subpixels SP is formed. Accordingly, as in FIG. 13, the low-reflection structure 120 (or the second low-reflection member 122') may include an organic material. In addition, the low-reflection structure 120 (or the second low-reflection member 122') may be placed between the passivation layer 111c and the cathode electrode 117. The display apparatus 100 according to the fifth embodiment of the present disclosure can be formed on the organic layer shielding portion OCP by utilizing a process line for forming the color filter CF with the low-reflection structure 120, so that production energy can be reduced.

Referring to FIG. 13, in the display apparatus 100 according to the fifth embodiment of the present disclosure, each of the gate driving area GIPA and the line area LNA may include a planarization layer 113 disposed between the substrate 110 and the cathode electrode 117. Since the planarization layer 113 is formed of an organic material, it can be disconnected by the organic layer shielding portion OCP (or the first organic layer shielding portion OCP1) like the organic light-emitting layer 116. Accordingly, the planarization layer 113 can be formed discontinuously by the organic layer shielding portion OCP provided in the gate driver GD, and thus the planarization layer 113 cannot become a moisture permeation path.

Referring again to FIG. 13, the low-reflection structure 120 (or the second low-reflection member 122') may be positioned spaced apart from each of the planarization layer 113 positioned in the gate driving area GIPA and the planarization layer 113 positioned in the line area LNA. In one embodiment, a first planarization layer 113 is between a first portion of the substrate 110 and a first portion of the cathode electrode 117 in the gate driving area GIPA and the line area LNA includes a second planarization layer 113 between a second portion of the substrate 110 and a second portion of the cathode electrode 117 in the line area LNA. The low-reflection structure 120 (or the second low-reflection member 122') may be arranged to be spaced apart from the first planarization layer 113 of the gate driving area GIPA and the second planarization layer 113 of the line area LNA by a predetermined distance D. The predetermined distance D may be a process margin in which the low-reflection structure 120 (or the second low-reflection member 122') and the planarization layer 113 are not connected. As described above, since the low-reflection structure 120 (or the second low-reflection member 122') includes an organic material, when the low-reflection structure 120 (or the second low-reflection member 122') and the planarization layer 113 are connected, it can become a moisture and oxygen permeation path. Accordingly, in the display apparatus 100 according to the fifth embodiment of the present disclosure, the low-reflection structure 120 (or the second low-reflection member 122') is positioned spaced apart from the planarization layer 113 of the gate driving area GIPA and the planarization layer 113 of the line area LNA, so that moisture penetration through the planarization layer 113 and the low-reflection structure 120 can be prevented.

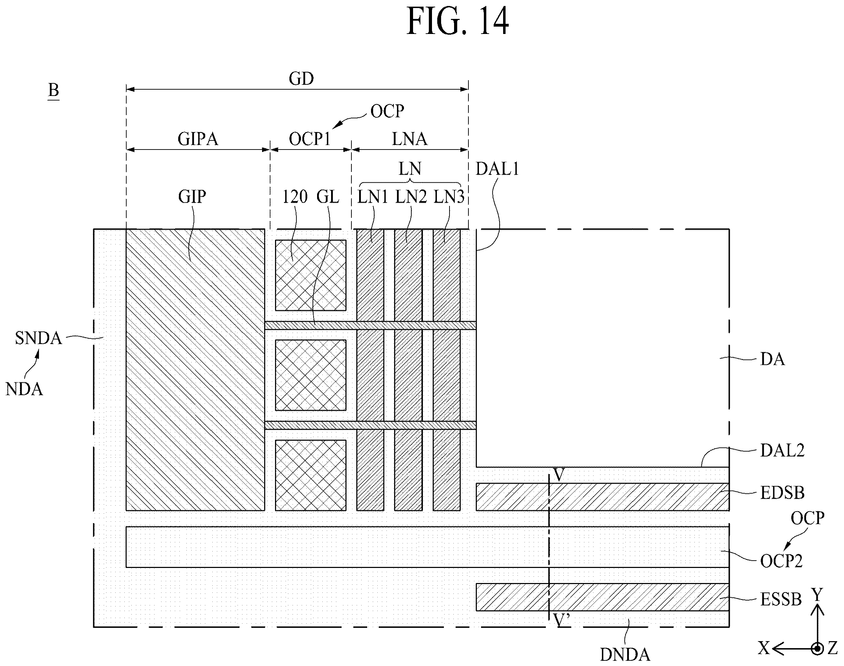

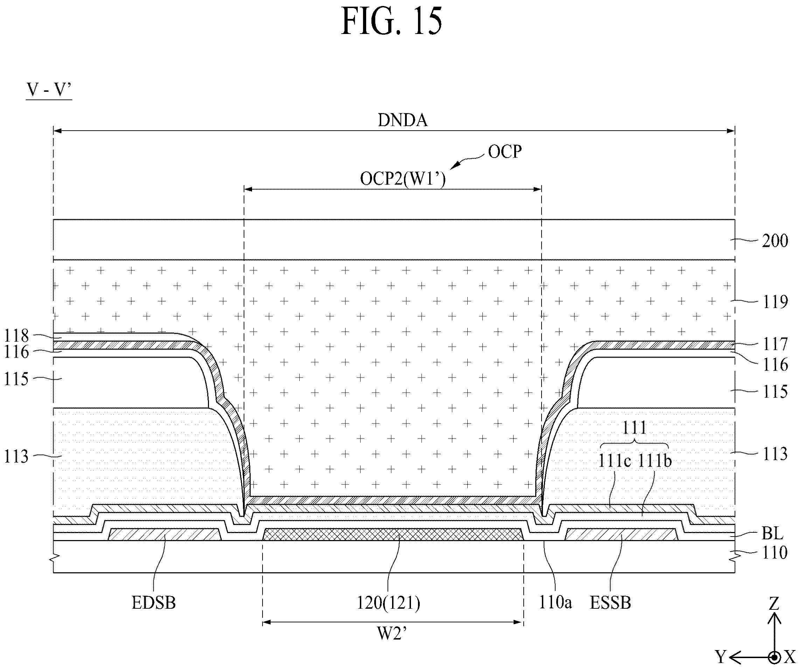

FIG. 14 is a schematic enlarged view of part B of FIG. 1 according to one embodiment, and FIG. 15 is a schematic cross-sectional view of line V-V' shown in FIG. 14 according to one embodiment.

Referring to FIG. 14, in the display apparatus 100 according to one embodiment of the present disclosure, the non-display area NDA may include a side non-display area SNDA and a bottom non-display area DNDA. The side non-display area SNDA may include a gate driver GD arranged along a first side DAL1 (e.g., parallel) of the display area DA. The first side DAL1 of the display area DA may be a side parallel to the first direction (Y-axis direction) in the display area DA. The bottom non-display area DNDA may be connected to the side non-display area SNDA. The bottom non-display area DNDA may include a pixel power shorting bar EDSB and a common power shorting bar ESSB arranged along a second side DAL2 (e.g., parallel) of the display area DA. The second side DAL2 of the display area DA may be a side parallel to the second direction (X-axis direction) in the display area DA.

As shown in FIG. 14, the organic layer shielding portion OCP may include a first organic layer shielding portion OCP1 and a second organic layer shielding portion OCP2. Since each of the first organic layer shielding portion OCP1 and the second organic layer shielding portion OCP2 has a same structure as the organic layer shielding portion OCP described above (e.g., a structure in which the organic layers are disconnected), a description thereof is omitted.

The first organic layer shielding portion OCP1 may be provided between the gate driving portion GIPA of the gate driver GD of the side non-display area SNDA and the line area LNA. The second organic layer shielding portion OCP2 may be provided between the pixel power shorting bar EDSB and the common power shorting bar ESSB of the bottom non-display area DNDA.

According to one embodiment of the present disclosure, the display apparatus 100 includes the first organic layer shielding portion OCP1 in the side non-display area SNDA adjacent to the first side DAL1 of the display area DA, and the second organic layer shielding portion OCP2 in the lower non-display area DNDA adjacent to the second side DAL2 of the display area DA, such that the first organic layer shielding portion OCP1 and the second organic layer shielding portion OCP2 can be structured to surround the display area DA in a remaining non-display area NDA except for the non-display area (or an upper non-display area) in which the pad portion PA is present. Accordingly, in the display apparatus 100 according to one embodiment of the present disclosure, the moisture permeation path can be blocked by the first organic layer shielding portion OCP1 and the second organic layer shielding portion OCP2, so that the reliability of the organic light-emitting element layer E can be improved.

Meanwhile, referring to FIG. 1, in the display apparatus 100 according to one embodiment of the present disclosure, the non-display area NDA (or the bottom non-display area DNDA) where the second organic layer shielding portion OCP2 is disposed may be provided to be wider than the non-display area NDA (or the side non-display area SNDA) where the gate driver GD is disposed. This is because the side non-display area SNDA is provided on both sides of the display area DA and is therefore visible to the user, whereas the bottom non-display area DNDA is provided below the display area DA and is therefore invisible to the user. For example, the non-display area DNDA may be positioned inside a stand that supports the display apparatus, and thus may not be visible to the user. Accordingly, as shown in FIG. 15, the display apparatus 100 according to one embodiment of the present disclosure may have a structural feature in which a width W1' of the second organic layer shielding portion OCP2 is wider than a width W1 (shown in FIG. 4) of the first organic layer shielding portion OCP1.

As shown in FIG. 15, the low-reflection structure 120 (or the first low-reflection structure 121) that can reduce or prevent external light reflection can be placed on the second organic layer shielding portion OCP2. Since the width W1' of the second organic layer shielding portion OCP2 is provided to be wider than the width W1 (shown in FIG. 4) of the first organic layer shielding portion OCP1, a width W2' of the low-reflection structure 120 (or the first low-reflection structure 121) arranged on the second organic layer shielding portion OCP2 may be provided to be wider than a width W2 of the low-reflection structure 120 (or the first low-reflection structure 121) arranged on the first organic layer shielding portion OCP1. Accordingly, in the display apparatus 100 according to one embodiment of the present disclosure, a moisture permeation path can be blocked by the first organic layer shielding portion OCP1 and the second organic layer shielding portion OCP2, and external light reflection can be reduced or prevented by the low-reflection structure 120 (or the first low-reflection structure 121) provided in each of the first organic layer shielding portion OCP1 and the second organic layer shielding portion OCP2.

Meanwhile, in FIG. 15, the low-reflection structure 120 is described as being placed on the upper surface 110a of the substrate 110 as an example, but is not limited thereto, and if external light reflection can be reduced or prevented, the low-reflection structure 120 may be placed on another layer (e.g., between the buffer layer BL and the interlayer insulating layer 111b). In addition, in FIG. 15, the low-reflection structure 120 is provided as an example of being provided as a single layer, but it is not limited thereto, and if it is possible to reduce or prevent external light reflection, the low-reflection structure 120 may be provided as a plurality of multi-layer. In addition, the multi-layer low-reflection structure 120 may be provided as a same material or as different materials.

Embodiments of the present disclosure have been described in more detail with reference to the accompanying drawings, but the present disclosure is not necessarily limited to these embodiments and may be practiced in various modifications without departing from the technical ideas of the present disclosure. Accordingly, the embodiments disclosed herein are intended to illustrate, not limit, the technical ideas of the present disclosure, and the scope of the technical ideas of the present disclosure is not limited by these embodiments. Therefore, the embodiments described above are exemplary in all respects and should be understood as non-limiting. All technical ideas within the scope of protection of this disclosure shall be construed to be included within the scope of the claims of this disclosure.

The display apparatus according to the present disclosure is provided the organic layer shielding portion in the non-display area, whereby moisture penetration can be reduced or prevented.

The display apparatus according to the present disclosure is provided that the low-reflection structure is provided so as to partially overlap with the organic layer shielding, thereby reducing or preventing external light reflection.

The display apparatus according to the present disclosure can improve the visibility of an image because the reflection of external light can be reduced or prevented by the low-reflection structure.

The display apparatus according to the present disclosure is provided that a barrier function can be improved by providing the low-reflection structure including a metal material, so that hydrogen penetration can be reduced or prevented.

The display apparatus according to the present disclosure is provided that the low-reflection structure includes a metal material and is electrically connected to the line of the non-display area, so that a width of the line can be reduced, and thus a size of the non-display area (or the bezel) can be reduced.

Since the display apparatus according to the present disclosure can form the low-reflection structure on the substrate by utilizing the process line of the substrate (or the lower substrate), production energy can be reduced through process optimization.

The effects to be obtained from the present disclosure are not limited to those mentioned above, and other effects not mentioned will be apparent to one of ordinary skill in the art from the description.

Also disclosed herein are a number of examples according to the following numbered clauses:
1. A display apparatus comprising:
   a substrate including a display area in which a plurality of pixels are arranged and a non-display area around the display area, each of the plurality of pixels having a plurality of subpixels;
   a cathode electrode on the substrate, the cathode electrode disposed in the display area and in a part of the non-display area;
   an organic layer under the cathode electrode in the display area and in a portion of the non-display area;
   an organic layer shielding portion in the non-display area, wherein the organic layer is disposed in the portion of the non-display area without being disposed in the organic layer shielding portion; and
   a low-reflection structure overlapping at least a part of the organic layer shielding portion, the low-reflection structure between the cathode electrode and the substrate in the non-display area.
2. The display apparatus of clause 1, wherein the non-display area includes a gate driver that comprises a gate driving area and a line area that is spaced apart from the gate driving area, and the low-reflection structure is between the gate driving area and the line area.
3. The display apparatus of clause 2, further comprising:
   a gate line in the gate driving area, the gate line non-overlapping with the low-reflection structure.
4. The display apparatus of any of clause 1 to clause 3, wherein the low-reflection structure is in direct contact with a surface of the substrate.
5. The display apparatus of any of clauses 1 - 4, wherein a width of the low-reflection structure is less than a width of the organic layer shielding portion.
6. The display apparatus of any of clauses 1 - 5, wherein the low-reflection structure comprises a low-reflectivity metal material.
7. The display apparatus of clause 6, wherein the low-reflectivity metal material is at least one of copper, molybdenum titanium, or tungsten oxide.
8. The display apparatus of any of clauses 1 to clause 4, wherein a width of the low-reflection structure is wider than a width of the organic layer shielding portion.
9. The display apparatus of clause 2 or clause 3, wherein the line area includes:
   a first line adjacent to the low-reflection structure without another line between the low-reflection structure and the first line, the first line connected to the low-reflection structure; and
   a second line spaced apart from the low-reflection structure with the first line between the low-reflection structure and the second line.
10. The display apparatus of clause 9, wherein a width of the first line is less than a width of the second line.
11. The display apparatus of clause 8, wherein the organic layer shielding portion comprises:
   a buffer layer between the cathode electrode and the substrate; and
   an interlayer insulating layer between the buffer layer and the cathode electrode,
   wherein the low-reflection structure is between the buffer layer and the interlayer insulating layer.
12. The display apparatus of clause 11, wherein the line area includes a first line positioned adjacent to the low-reflection structure without another line between the first line and the low-reflection structure,
   wherein the low-reflection structure is in contact with the first line through a contact hole in the buffer layer.
13. The display apparatus of any of clause 1 to clause 12, wherein the low-reflection structure comprises:
   at least one first low-reflection member on an upper surface of the substrate; and
   a second low-reflection member arranged in a different layer from the at least one first low-reflection member and partially overlapping the at least one first low-reflection member.
14. The display apparatus of clause 13, wherein the at least one first low-reflection member comprises a metal material and the second low-reflection member comprises an organic material.
15. The display apparatus of clause 13 or clause 14, wherein the at least one first low-reflection member comprises a plurality of first low-reflection members and the second low-reflection member is on at least one of the plurality of first low-reflection members.
16. The display apparatus of any of clause 13 to clause 15, wherein the at least one first low-reflection member comprises one of a stripe shape, a mesh shape, or a square ring shape and the second low-reflection member comprises one of a stripe shape or a square shape.
17. The display apparatus of clause 2 or clause 3, wherein the low-reflection structure comprises an organic material.
18. The display apparatus of clause 17, wherein the gate driving area includes a first planarization layer between a first portion of the substrate and a first portion of the cathode electrode in the gate driving area, and the line area includes a second planarization layer between a second portion of the substrate and a second portion of the cathode electrode in the line area,
   wherein the low-reflection structure is spaced apart from the first planarization layer in the gate driving area and the second planarization layer in the line area.
19. The display apparatus of any of clause 1 to clause 18, wherein the non-display area includes:
   a side non-display area including a gate driver arranged along a first side of the display area; and
   a lower non-display area that is connected to the side non-display area, the lower non-display area including a pixel power shorting bar and a common power shorting bar arranged along a second side of the display area,
   wherein the organic layer shielding portion includes:
      a first organic layer shielding portion between a gate driving area and a line area of the gate driver of the side non-display area; and
      a second organic layer shielding portion between the pixel power shorting bar and the common power shorting bar of the lower non-display area.
20. The display apparatus of clause 19, wherein a width of the second organic layer shielding portion is wider than a width of the first organic layer shielding portion.
21. A display apparatus comprising:
   a substrate including a display area and a non-display area around the display area;
   a gate driver circuit in a first portion of the non-display area;
   a signal line in a second portion of the non-display area that is spaced apart from the first portion of the non-display area;
   an organic light emitting layer in the display area and the non-display area; and
   a cathode electrode on the organic light emitting layer in the display area and a part of the non-display area,
   wherein the organic light emitting layer is disposed over the gate driver circuit in the first portion of the non-display area and is disposed over the signal line in a second portion of the non-display area without being disposed over a third portion of the non-display area that is between the first portion and the second portion of the non-display area.
22. The display apparatus of clause 21, further comprising:
   a low-reflection structure in the third portion of the non-display area, the low-reflection structure between the cathode electrode and the substrate in the third portion of the non-display area.
23. The display apparatus of clause 22, wherein the low-reflection structure comprises metal or an organic material.
24. The display apparatus of clause 22 or clause 23, wherein the low-reflection structure is in direct contact with the substrate.
25. The display apparatus of any of clause 22 to clause 24, wherein the low-reflection structure is in a same layer as the signal line.
26. The display apparatus of any of clause 22 to clause 25, further comprising:
   a gate line that is connected to the gate driver circuit in the first portion of the non-display area, the gate line extending to the display area along a first direction through the third portion of the non-display area and the second portion of the non-display area,
   wherein the gate line is non-overlapping with the low-reflection structure,
   wherein the signal line extends in a second direction that is different from the first direction.
27. The display apparatus of any of clause 22 to clause 26, wherein a width of the low-reflection structure is less than a width of the third portion of the non-display area.
28. The display apparatus of any of clause 22 to clause 26, wherein a width of the low-reflection structure is wider than a width of the third portion of the non-display area.
29. The display apparatus of any of clause 22 to clause 28, wherein the signal line comprises a first line and a second line such that the first line is between the low-reflection structure and the second line,
   wherein a width of the second line is wider than a width of the first line.
30. The display apparatus of clause 28, wherein the first line includes a portion that extends from a side of the first line and the low-reflection structure is in direct contact with the extended portion.
31. The display apparatus of any of clause 22 to clause 30, further comprising:
   a buffer layer in the third portion of the non-display area; and
   an interlayer insulating layer overlapping the buffer layer in the third portion of the non-display area such that the low-reflection structure is between the buffer layer and the interlayer insulating layer in the third portion of the non-display area.
32. The display apparatus of any of clause 22 to clause 31, wherein the low-reflection structure comprises:
   at least one first low-reflection member on the substrate; and
   a second low-reflection member overlapping the at least one first low-reflection member,
   wherein the at least one first low-reflection member comprises a metal material and the second low-reflection member comprises an organic material.

## Claims

1. A display apparatus comprising:
a substrate including a display area in which a plurality of pixels are arranged and a non-display area around the display area, each of the plurality of pixels having a plurality of subpixels;
a cathode electrode on the substrate, the cathode electrode disposed in the display area and in a part of the non-display area;
an organic layer under the cathode electrode in the display area and in a portion of the non-display area;
an organic layer shielding portion in the non-display area, wherein the organic layer is disposed in the portion of the non-display area without being disposed in the organic layer shielding portion; and
a low-reflection structure overlapping at least a part of the organic layer shielding portion, wherein the low-reflection structure is disposed between the cathode electrode and the substrate in the non-display area.

2. The display apparatus of claim 1, wherein the non-display area includes a gate driver that comprises a gate driving area and a line area that is spaced apart from the gate driving area, and the low-reflection structure is between the gate driving area and the line area;
and optionally further comprising:
a gate line in the gate driving area, the gate line non-overlapping with the low-reflection structure.

3. The display apparatus of any of claim 1 or claim 2, wherein the low-reflection structure is in direct contact with a surface of the substrate.

4. The display apparatus of any of claim 1 to claim 3, wherein a width of the low-reflection structure is less than a width of the organic layer shielding portion.

5. The display apparatus of any of claim 1 to claim 4, wherein the low-reflection structure comprises a low-reflectivity metal material; and optionally
wherein the low-reflectivity metal material is at least one of copper, molybdenum titanium, or tungsten oxide.

6. The display apparatus of any of claim 1 to claim 3, wherein a width of the low-reflection structure is greater than a width of the organic layer shielding portion.

7. The display apparatus of claim 2, wherein the line area includes:
a first line adjacent to the low-reflection structure without another line between the low-reflection structure and the first line, the first line connected to the low-reflection structure; and
a second line spaced apart from the low-reflection structure with the first line between the low-reflection structure and the second line.

8. The display apparatus of claim 7, wherein a width of the first line is less than a width of the second line.

9. The display apparatus of claim 6, wherein the organic layer shielding portion comprises:
a buffer layer between the cathode electrode and the substrate; and
an interlayer insulating layer between the buffer layer and the cathode electrode,
wherein the low-reflection structure is between the buffer layer and the interlayer insulating layer; and optionally
wherein the line area includes a first line positioned adjacent to the low-reflection structure without another line between the first line and the low-reflection structure,
wherein the low-reflection structure is in contact with the first line through a contact hole in the buffer layer.

10. The display apparatus of any of claim 1 to claim 9, wherein the low-reflection structure comprises:
at least one first low-reflection member on an upper surface of the substrate; and
a second low-reflection member arranged in a different layer from the at least one first low-reflection member and partially overlapping the at least one first low-reflection member;
and optionally wherein the at least one first low-reflection member comprises a metal material and the second low-reflection member comprises an organic material.

11. The display apparatus of claim 10, wherein the at least one first low-reflection member comprises a plurality of first low-reflection members and the second low-reflection member is on at least one of the plurality of first low-reflection members.

12. The display apparatus of any of claim 10 or claim 11, wherein the at least one first low-reflection member comprises one of a stripe shape, a mesh shape, or a square ring shape and the second low-reflection member comprises one of a stripe shape or a square shape.

13. The display apparatus of claim 2, wherein the low-reflection structure comprises an organic material; and optionally
wherein the gate driving area includes a first planarization layer between a first portion of the substrate and a first portion of the cathode electrode in the gate driving area, and the line area includes a second planarization layer between a second portion of the substrate and a second portion of the cathode electrode in the line area,
wherein the low-reflection structure is spaced apart from the first planarization layer in the gate driving area and the second planarization layer in the line area.

14. The display apparatus of any of claim 1 to claim 13, wherein the non-display area includes:
a side non-display area including a gate driver arranged along a first side of the display area; and
a lower non-display area that is connected to the side non-display area, the lower non-display area including a pixel power shorting bar and a common power shorting bar arranged along a second side of the display area,
wherein the organic layer shielding portion includes:
a first organic layer shielding portion between a gate driving area and a line area of the gate driver of the side non-display area; and
a second organic layer shielding portion between the pixel power shorting bar and the common power shorting bar of the lower non-display area.

15. The display apparatus of claim 14, wherein a width of the second organic layer shielding portion is greater than a width of the first organic layer shielding portion.
